# EUROPEAN PATENT APPLICATION

(11) **EP 4 514 092 A1**
(43) Date of publication of application: **26.02.2025**
(21) Application number: 24191290.6
(22) Date of filing: 26.07.2024
(51) Int. Cl.: H10D 30/01, H01L 21/02, H10D 30/67, H10D 86/01

(54) **METHOD FOR MANUFACTURING TRANSISTOR, DISPLAY DEVICE INCLUDING THE TRANSISTOR, AND METHOD FOR MANUFACTURING THE DISPLAY DEVICE**

(30) Priority: 26.07.2023 KR 20230097174
(71) Applicant: Samsung Display Co., Ltd., Gyeonggi-Do (KR)
(72) Inventor: SEO, Jongoh, Yongin-si (KR); JIN, Donggyu, Yongin-si (KR)
(74) Representative: Marks & Clerk LLP

(57) **Abstract**

A method for manufacturing a transistor includes providing a preliminary polysilicon layer including an upper surface on which protrusions are formed, providing a sacrificial layer on the upper surface of the preliminary polysilicon layer, providing argon (Ar) ions in an upper portion of the sacrificial layer to dope the sacrificial layer and the preliminary polysilicon layer, providing an etchant to an upper portion of the doped sacrificial layer, and removing the sacrificial layer, and etching the protrusions to form a polysilicon layer.

## Description

### BACKGROUND

### 1. Technical Field

This disclosure relates to a method for manufacturing a transistor including a polysilicon layer, a display device including the transistor having a polysilicon layer, and a method for manufacturing the display device.

### 2. Description of Related Art

A display device provides a variety of functions for allowing communication with a user, such as displaying an image to provide information to the user or sensing a user input.

A display device may include a transistor including a semiconductor pattern and a gate constituting a source, a drain, and a channel. Recent display devices have used a polysilicon(p-Si) layer in a semiconductor pattern to improve the performance of the transistor. The polysilicon layer may be formed by crystallizing amorphous silicon(a-Si), and in order for a transistor formed of the polysilicon layer to exhibit excellent performance, it may be desirable to control the crystallization quality and surface quality of the polysilicon layer.

It is to be understood that this background of the technology section is, in part, intended to provide useful background for understanding the technology. However, this background of the technology section may also include ideas, concepts, or recognitions that were not part of what was known or appreciated by those skilled in the pertinent art prior to a corresponding effective filing date of the subject matter disclosed herein.

### SUMMARY

The disclosure provides a method for manufacturing a transistor including a polysilicon layer, the surface of which has improved surface quality.

The disclosure also provides a display device including a transistor having a polysilicon layer having excellent surface quality, and a method for manufacturing the display device.

An embodiment provides a method for manufacturing a transistor, wherein the method may include providing a preliminary polysilicon layer including an upper surface on which protrusions are formed, providing a sacrificial layer on the upper surface of the preliminary polysilicon layer, providing argon (Ar) ions in an upper portion of the sacrificial layer to dope the sacrificial layer and the preliminary polysilicon layer, providing an etchant to an upper portion of the doped sacrificial layer, and removing the sacrificial layer, and etching the protrusions to form a polysilicon layer.

In an embodiment, a surface roughness of an upper surface of the polysilicon layer may be less than about 50% of a surface roughness of the upper surface of the preliminary polysilicon layer.

In an embodiment, the preliminary polysilicon layer may be formed in an operation of performing crystallization by providing an excimer laser to an amorphous silicon layer.

In an embodiment, the sacrificial layer may include silicon oxide(SiOx).

In an embodiment, the average thickness of the sacrificial layer may be in a range of about 300 Å to about 1000 Å.

In an embodiment, the providing of the argon ions may include providing the argon ions with an acceleration voltage in a range of about 5 keV to about 80 keV, and a dose amount in a range of about 1.0E15 to about 1.0E20 in an ion implantation facility.

In an embodiment, the etchant may be an acidic solution containing hydrogen fluoride (HF) and ammonium fluoride (NH₄F).

In an embodiment, a ratio of an etch rate of the doped sacrificial layer to an etch rate of the doped preliminary polysilicon layer may be less than about 5.0.

In an embodiment, a display device may include a base layer, a circuit layer disposed on the base layer, and including a transistor and insulation layers, and a display layer disposed on the circuit layer, and including a light emitting element electrically connected to the transistor, wherein the transistor includes a polysilicon layer including argon (Ar).

In an embodiment, the transistor may include a semiconductor pattern including a source, a channel, and a drain, and a gate disposed overlapping the semiconductor pattern, wherein the semiconductor pattern may be the polysilicon layer.

In an embodiment, the circuit layer may include a gate insulation layer disposed between the semiconductor pattern and the gate, the gate may be disposed on an upper side of the semiconductor pattern with the gate insulation layer disposed between the gate and the semiconductor pattern, and at least part of the semiconductor pattern that is adjacent to the gate insulation layer may include the argon.

In an embodiment, a surface roughness of the polysilicon layer may be about 10 nm or less.

In an embodiment, a method for manufacturing a display device may include providing a base layer, forming, on the base layer, a circuit layer including transistors and insulation layers, and providing a display layer on the circuit layer, wherein the forming of the circuit layer may include forming an amorphous silicon layer on the base layer, crystallizing the amorphous silicon layer into a preliminary polysilicon layer, providing a sacrificial layer on the preliminary polysilicon layer, doping the sacrificial layer and the preliminary polysilicon layer with argon, providing an etchant on the doped sacrificial layer and the doped preliminary polysilicon layer, and removing the sacrificial layer, and reducing a surface roughness of the preliminary polysilicon layer to form a polysilicon layer.

In an embodiment, at least one of the transistors may include the polysilicon layer.

In an embodiment, the forming of the circuit layer may further include manufacturing a transistor by providing a gate insulation layer on the polysilicon layer, forming a gate overlapping the polysilicon layer on the gate insulation layer, and forming the polysilicon layer as a semiconductor pattern divided into a source, a channel, and a drain.

In an embodiment, the crystallizing of the amorphous silicon layer may include providing an excimer laser to the amorphous silicon layer.

In an embodiment, the sacrificial layer may include silicon oxide(SiOx).

In an embodiment, the average thickness of the sacrificial layer may be in a range of about 300 Å to about 1000 Å.

In an embodiment, the doping of the sacrificial layer may include providing argon ions with an acceleration voltage in a range of about 5 keV to about 80 keV, and a dose amount in a range of about 1.0E15 to about 1.0E20 in an ion implantation facility.

In an embodiment, the etchant may be an acidic solution containing hydrogen fluoride (HF) and ammonium fluoride (NH₄F).

At least some of the above and other features of the invention are set out in the claims.

### BRIEF DESCRIPTION OF THE DRAWINGS

The accompanying drawings are included to provide a further understanding of the disclosure, and are incorporated in and constitute a part of this specification. The drawings illustrate embodiments and, together with the description, serve to explain principles of the disclosure. In the drawings:
FIG. 1 is a schematic perspective view of a display device according to an embodiment;
FIG. 2 is an exploded schematic perspective view of a display device according to an embodiment;
FIG. 3 is a schematic cross-sectional view showing a portion corresponding to line I-I' of FIG. 2;
FIG. 4 is a schematic plan view of a display panel according to an embodiment;
FIG. 5 is a schematic diagram of an equivalent circuit of a pixel according to an embodiment;
FIG. 6A is a schematic cross-sectional view of a portion of a display module according to an embodiment;
FIG. 6B is a schematic cross-sectional view showing a portion of a transistor according to an embodiment;
FIG. 7 is a flowchart of a method for manufacturing a thin-film transistor according to an embodiment;
FIG. 8A to FIG. 8G are each a schematic drawing showing an operation of a method for manufacturing a thin-film transistor according to an embodiment;
FIG. 9 is a schematic cross-sectional view showing a portion of a polysilicon layer according to an embodiment;
FIG. 10A is a schematic view showing a planar image of a preliminary polysilicon layer according to an embodiment;
FIG. 10B is a schematic view showing a planar image of a polysilicon layer according to an embodiment;
FIG. 11A to FIG. 11D are each a schematic view showing simulation results for argon doping according to an embodiment;
FIG. 12A is a view showing a schematic cross-sectional image of a preliminary polysilicon layer according to an embodiment; and
FIG. 12B is a view showing a schematic cross-sectional image of a polysilicon layer according to an embodiment.

### DETAILED DESCRIPTION OF THE EMBODIMENTS

The disclosure may be modified in many alternate forms, and thus only certain specific embodiments will be disclosed in the drawings and described in detail. It should be understood, however, that these embodiments are not intended to limit the disclosure to the particular forms disclosed, but rather, the disclosure is intended to cover all modifications, equivalents, and alternatives.

As used herein, the singular forms, "a," "an," and "the" are intended to include the plural forms as well, unless the context clearly indicates otherwise.

In the specification and the claims, the term "and/or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/or."

In the specification and the claims, the phrase "at least one of" is intended to include the meaning of "at least one selected from the group of" for the purpose of its meaning and interpretation. For example, "at least one of A and B" may be understood to mean "A, B, or A and B."

In the specification, when an element (or a region, a layer, a portion, etc.) is referred to as being "on," "connected to," or "coupled to" another element, it means that the element may be directly disposed on/connected to/coupled to the other element, or that a third element may be disposed therebetween.

Like reference numerals refer to like elements. Also, in the drawings, the thickness, the ratio, and the dimensions of elements may be exaggerated for an effective description of technical contents.

It will be understood that, although the terms "first," "second," etc. may be used herein to describe various elements, these elements should not be limited by these terms. These terms are only used to distinguish one element from another. For example, a first element may be referred to as a second element, and a second element may also be referred to as a first element in a similar manner without departing the scope of rights of the disclosure.

In addition, terms such as "below," "lower," "above," "upper," and the like are used to describe the relationship of the elements shown in the drawings. The terms are used as a relative concept and are described with reference to the direction indicated in the drawings.

It should be understood that the terms "comprise," "include," and "have" are intended to specify the presence of stated features, integers, steps, operations, elements, components, or combinations thereof in the disclosure, but do not preclude the presence or addition of one or more other features, integers, steps, operations, elements, components, or combinations thereof.

In the disclosure, being "directly disposed" may mean that there is no layer, film, region, plate, or the like added between a portion of a layer, a film, a region, a plate, or the like and other portions. For example, being "directly disposed" may mean being disposed without additional members such as an adhesive member between two layers or two members.

The terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art.

"About" or "approximately" or "substantially" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Unless otherwise defined or implied, all terms (including technical and scientific terms) used herein have the same meaning as commonly understood by one of ordinary skill in the art to which the disclosure pertains. It is also to be understood that terms such as terms defined in commonly used dictionaries should be interpreted as having meanings consistent with the meanings in the context of the related art, and should not be interpreted in too ideal a sense or an overly formal sense unless explicitly defined herein.

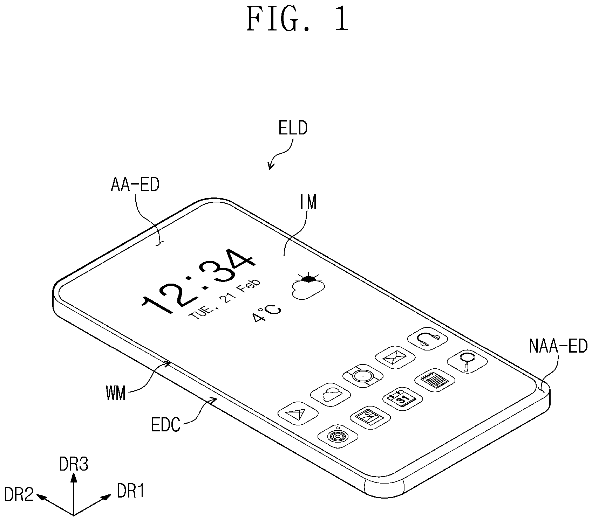

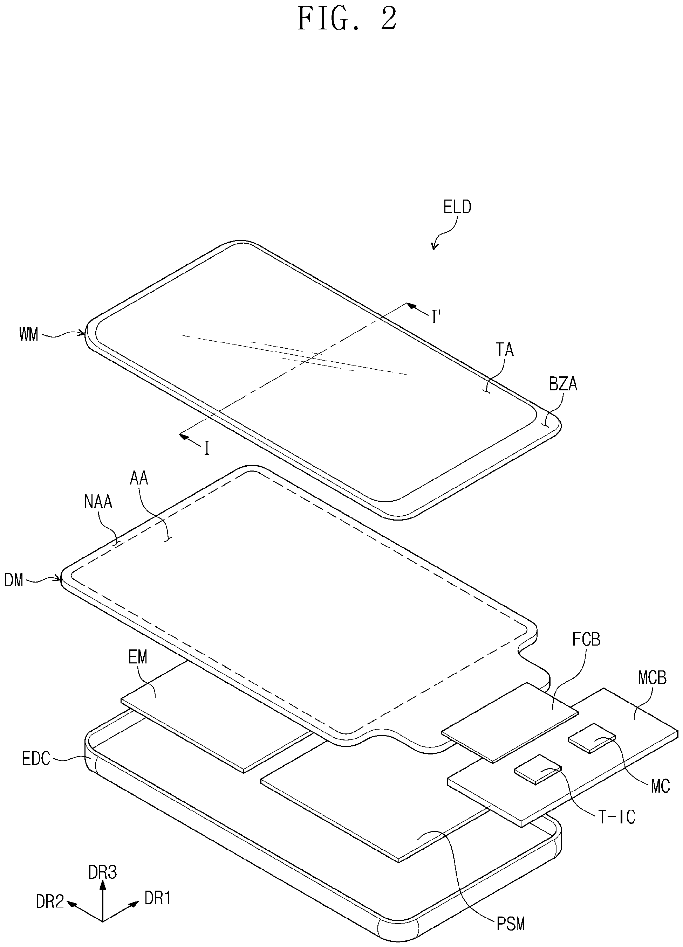

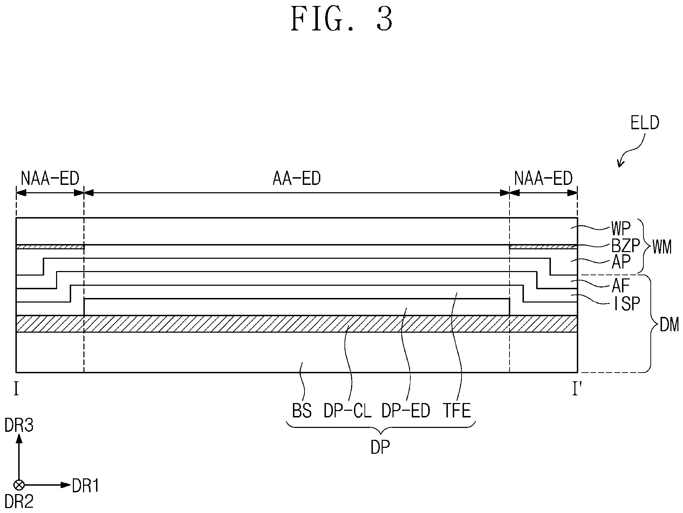

FIG. 1 is a schematic perspective view showing a display device according to an embodiment; FIG. 2 is an exploded schematic perspective view of a display device according to an embodiment; FIG. 3 is a schematic cross-sectional view of a display device according to an embodiment; FIG. 3 may be a cross-sectional view corresponding to line I-I' of FIG. 2.

Referring to FIG. 1, a display device ELD may be a device activated in response to an electrical signal and displaying images. For example, the display device ELD may be a large-sized device such as a television or an external billboard, or may be a small-and-medium-sized device such as a monitor, a mobile phone, a tablet, a navigation system unit, or a game console. However, embodiments of the display device ELD are merely examples, and the display device ELD is not limited to any one thereof without departing from the disclosure.

The display device ELD may be rigid or flexible. Being "flexible" refers to having properties of being able to be bent. For example, a flexible display device ELD may include a curved device, a rollable device, or a foldable device.

In FIG. 1 and the following drawings, a first direction axis DR1 to a third direction axis DR3 are illustrated, and directions indicated by the first to third direction axes DR1, DR2, and DR3 described in the specification are relative concepts, and may be converted into different directions. In addition, the directions indicated by the first to third direction axes DR1, DR2, and DR3 may be described as first to third directions DR1, DR2, and DR3, and may be denoted by the same reference numerals. In the specification, the first direction axis DR1 and the second direction axis DR2 are perpendicular to each other, and the third direction axis DR3 may be a normal direction with respect to a plane defined by the first direction axis DR1 and the second direction axis DR2.

The thickness direction of the display device ELD may be a direction parallel to a third direction axis DR3, which is a normal direction with respect to a plane defined by the first direction axis DR1 and the second direction axis DR2. In the specification, a front surface (or an upper surface) and a rear surface (or a lower surface) of members constituting the display device ELD may be defined on the basis of the third direction axis DR3. The front surface (or upper surface) and the rear surface (or lower surface) of members constituting the display device ELD may oppose each other in the third direction DR3, and a normal direction of each of the front surface and the rear surface may be substantially parallel to the third direction DR3. A separation distance between the front surface and the rear surface, which is defined in the third direction DR3, may correspond to the thickness of a member.

In the specification, "in a plan view" may be defined as a state viewed in the third direction DR3. In the specification, "in a cross-sectional view" may be defined as a state viewed in the first direction DR1 or the second direction DR2. Directions indicated by the first to third directions DR1, DR2, and DR3 are a relative concept, and may be converted to different directions.

The display device ELD according to an embodiment may display an image IM through an active region AA-ED. The active region AA-ED may include a plane defined by the first direction DR1 and the second direction DR2. The active region AA-ED may further include a curved surface bent from at least one side of the plane defined by the first direction DR1 and the second direction DR2. A surface on which the image IM is displayed may correspond to the front surface of the display device ELD. The image IM may include both a moving image and a still image.

A peripheral region NAA-ED is adjacent to the active region AA-ED. The peripheral region NAA-ED may surround the active region AA-ED. Accordingly, the shape of the active region AA-ED may substantially be defined by the peripheral region NAA-ED. However, this is only an illustrated example, and the peripheral region NAA-ED may be disposed adjacent to only one side of the active region AA-ED, or may be omitted. The display device ELD according to an embodiment may include an active region in various shapes, and is not limited to any one embodiment.

The display device ELD may have a rectangular shape which has short sides extended in the first direction DR1 in a plan view and long sides extended in the second direction DR2 intersecting the first direction DR1. However, embodiments are not limited thereto, and the display device ELD may have various shapes in a plan view, such as a circular shape and a polygonal shape.

The display device ELD may sense an external input applied from the outside. The external input may include various forms of inputs such as force, pressure, temperature, light, and the like.

Referring to FIG. 1 to FIG. 3, the display device ELD according to an embodiment may include a display module DM. The display module DM may be a component configured to generate an image, and sense an input applied from the outside. The display module DM according to an embodiment may include a display panel DP and an input sensor ISP disposed on the display panel DP. The display module DM of an embodiment may further include an optical layer AF disposed on the input sensor ISP. The display panel DP according to an embodiment may include a thin-film transistor manufactured by a method for manufacturing a thin-film transistor according to an embodiment.

The display device ELD of an embodiment may include a window module WM disposed in an upper portion of the display module DM. The display device ELD may further include an electronic module EM, a power module PSM, a housing EDC, and the like.

In the display module DM according to an embodiment, an active region AA and a peripheral region NAA may be defined. The active region AA may be a region activated in response to an electrical signal. The peripheral region NAA may be a region positioned adjacent to at least one side of the active region AA.

The active region AA may correspond to the active region AA-ED of the electronic device ELD illustrated in FIG. 1. The peripheral region NAA may be disposed surrounding the active region AA. However, embodiments are not limited thereto, and unlike what is illustrated in FIG. 2 and the like, in an embodiment, a portion of the peripheral region NAA may be omitted. The peripheral region NAA may correspond to the peripheral region NAA-ED of the display device illustrated in FIG. 1.

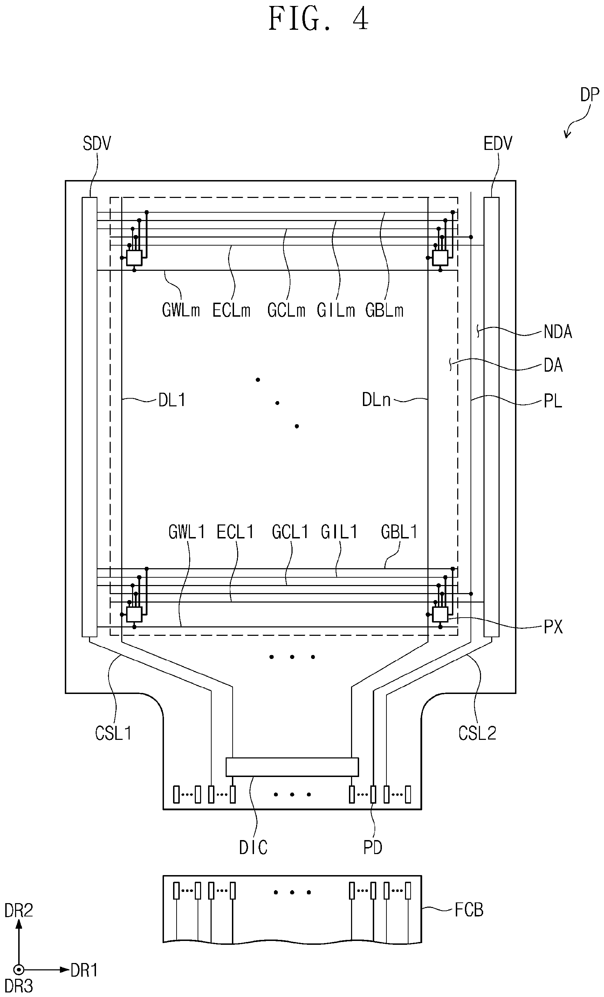

The display module DM according to an embodiment may include the peripheral region NAA disposed on at least one side of the active region AA, and in the peripheral region NAA, a region in which pads PD (see FIG. 4) are disposed may also be referred to as a pad region. The pad region may be a portion of the peripheral region NAA. In the pad region, a driving circuit, a driving line, or the like for driving the active region AA may be disposed. The driving circuit, the driving line, or the like may be electrically connected to a thin-film transistor manufactured by the method for manufacturing a thin-film transistor according to an embodiment.

The window module WM may be disposed on the display module DM to protect the display module DM from external impacts or scratches. The window module WM may cover the entire outer side of the display module DM. The front surface of the window module WM may correspond to an upper surface of the display device ELD described above.

In an embodiment, the window module WM may include a base substrate WP. The base substrate WP may include an optically transparent insulation material. The base substrate WP may include at least one of a glass substrate and a synthetic resin film. The base substrate WP may have a single-layered structure, or a multi-layered structure in which multiple films are coupled. The window module WM may further include a functional layer such as an anti-fingerprint layer, a phase control layer, or a hard coating layer disposed on the base substrate WP.

The window module WM may further include an adhesive layer AP. The base substrate WP and the display module DM may be coupled to each other through the adhesive layer AP. However, embodiments are not limited thereto, and the adhesive layer AP may be omitted, and the window module WM may be directly disposed on the display module DM.

The window module WM may be divided into a transmissive portion TA and a bezel portion BZA. The transmissive portion TA may be a portion corresponding to the active region AA of the display module DM, and the bezel portion BZA may be a portion corresponding to the peripheral region NAA of the display module DM. The bezel portion BZA may define the shape of the transmissive portion TA. The bezel portion BZA may be adjacent to the transmissive portion TA, and may surround the transmissive portion TA. However, embodiments are not limited to what is illustrated, and the bezel portion BZA may be disposed adjacent to only one side of the transmissive portion TA, or a portion of the bezel portion BZA may be omitted.

The window module WM may further include a bezel pattern BZP disposed corresponding to the bezel portion BZA. The bezel pattern BZP may be a color layer formed on one surface of the base substrate WP. The bezel pattern BZP may include a material having a color. For example, the bezel pattern BZP may include a colored organic film. The bezel pattern BZP may have a single-layered or multi-layered structure. The bezel portion BZA of the window module WM in which the bezel pattern BZP is placed may have lower light transmittance than the transmissive portion TA.

The display module DM may further include a main circuit board MCB, a flexible circuit film FCB, and a data driver, a sensor control circuit T-IC, and a main controller MC.

The main circuit board MCB may be electrically connected to the display module DM through the flexible circuit film FCB. The main circuit board MCB may be electrically connected to the electronic module EM through a connector.

The flexible circuit film FCB may be connected to each of the display panel DP and the input sensor ISP to connect the display panel DP and the input sensor ISP to the main circuit board MCB. The input sensor ISP may be electrically connected to the display panel DP to be electrically connected to the main circuit board MCB through a flexible circuit film FCB. However, embodiments are not limited thereto, and the input sensor ISP may be electrically connected to the main circuit board MCB through an additional flexible circuit film, or the flexible circuit film FCB may be omitted and the main circuit board MCB may be directly connected to the display panel DP.

Each of the data driver, the sensor control circuit T-IC, and the main controller MC may be provided in the form of an integrated chip. The data driver may be mounted on the display module DM, and the sensor control circuit T-IC and the main controller MC may be mounted on the main circuit board MCB. However, embodiments are not limited thereto. For example, the data driver may be mounted on the flexible circuit film FCB.

The main controller MC may control the overall operation of the display device ELD. For example, the main controller MC may control the operation of the display panel DP and the input sensor ISP. The main controller MC may control the operation of the electronic module EM. The main controller MC may include at least one microprocessor.

The data driver may include a driving circuit for driving pixels of the display panel DP. The data driver may receive image data and a control signal from the main controller MC. For example, the control signal may include an input vertical synchronization signal, an input horizontal synchronization signal, a main clock, a data enable signal, and the like.

The sensor control circuit T-IC may provide an electrical signal for driving the input sensor ISP. The sensor control circuit T-IC may receive a control signal such as a clock signal from the main controller MC.

The electronic module EM may include various functional modules desirable for driving the display device ELD. For example, the electronic module EM may include a wireless communication module, an image input module, a sound input module, a sound output module, a memory, an external interface module, and the like. The electronic module EM may be mounted on the main circuit board MCB, or may be electrically connected to the main circuit board MCB through a separate flexible circuit board.

The power module PSM may be electrically connected to the electronic module EM. The power module PSM may supply power desirable for the overall operation of display device ELD. For example, the power module PSM may include a typical battery device.

The window module WM and the housing EDC may be coupled to each other to configure the appearance of the display device ELD. The window module WM and the housing EDC may be coupled to each other to form an internal space for accommodating components of the display device ELD. In the internal space, the display module DM, the flexible circuit film FCB, the main circuit board MCB, the electronic module EM, the power module PSM, and the like may be accommodated. A portion of the display module DM may be bent such that the flexible circuit film FCB and the main circuit board MCB face the rear surface of the display module DM and are stored in the housing EDC.

The housing EDC may include a material having relatively high rigidity. For example, the housing EDC may include glass, plastic, or a metal, or may include a frame and/or plate composed of a combination thereof. The housing EDC may protect the display module DM and the like, which are accommodated in the housing EDC, by either absorbing an impact applied from the outside or preventing foreign substances/moisture and the like from penetrating from the outside.

In the display device ELD of an embodiment, the display panel DP may be a component which substantially generates an image. The display panel DP may be a light emitting-type display panel, and for example, the display panel DP may be an organic light emitting display panel, an inorganic light emitting display panel, a quantum-dot display panel, a micro-LED display panel, or a nano-LED display panel. The display panel DP may be referred to as a display layer.

Referring to FIG. 3, the display panel DP may include a base layer BS, a circuit layer DP-CL, a display layer DP-ED, and an encapsulation layer TFE.

The base layer BS may be a member which provides a base surface on which the circuit layer DP-CL is disposed. The base layer BS may be a rigid substrate, or a flexible substrate capable of bending, folding, rolling, and the like. The base layer BS may be a glass substrate, a metal substrate, a polymer substrate, or the like. However, embodiments are not limited thereto, and the base layer BS may be an inorganic layer, an organic layer, or a composite material layer.

The base layer BS may have a multi-layered structure. For example, the base layer BS may include a first synthetic resin layer, an intermediate layer of a multi-layered or single-layered structure, and a second synthetic resin layer disposed on the intermediate layer. The intermediate layer may be referred to as a base barrier layer. The intermediate layer may include a silicon oxide(SiOx) layer and an amorphous silicon(a-Si) layer disposed above the silicon oxide layer, but embodiments are not particularly limited thereto. For example, the intermediate layer may include at least one of a silicon oxide layer, a silicon nitride layer, a silicon oxynitride layer, and an amorphous silicon layer.

Each of the first and second synthetic resin layers may include a polyimide-based resin. Each of the first and second synthetic resin layers may include at least one of an acrylate-based resin, a methacrylate-based resin, a polyisoprene-based resin, a vinyl-based resin, an epoxy-based resin, a urethane-based resin, a cellulose-based resin, a siloxane-based resin, a polyamide-based resin, and a perylene-based resin. In the specification, a "~"-based resin means that a functional group of "~" is included.

The circuit layer DP-CL may be disposed on the base layer BS. The circuit layer DP-CL may include an insulation layer, a semiconductor pattern, a conductive pattern, a signal line, and the like. The insulation layer, a semiconductor layer, and a conductive layer are formed on the base layer BS by coating, deposition, or the like, and thereafter, the insulation layer, the semiconductor layer, and the conductive layer may be selectively patterned by performing a photolithography process multiple times. Thereafter, the semiconductor pattern, the conductive pattern, and the signal line included in the circuit layer DP-CL may be formed. The circuit layer DP-CL may include inorganic insulation layers and organic insulation layers as the insulation layer. At least one of semiconductor patterns included in the circuit layer DP-CL may be manufactured by the method for manufacturing a thin-film transistor according to an embodiment.

The display layer DP-ED may be disposed on the circuit layer DP-CL. The display layer DP-ED may include a light emitting element. For example, the display layer DP-ED may include an organic light emitting material, an inorganic light emitting material, an organic-inorganic light emitting material, a quantum dot, a quantum rod, a micro-LED, or a nano-LED. Light emitting elements of the display layer DP-ED may be electrically connected to driving elements of the circuit layer DP-CL to display an image by generating light in response to a signal provided by the driving elements.

The encapsulation layer TFE may be disposed on the display layer DP-ED. The encapsulation layer TFE may protect the display layer DP-ED from foreign materials such as moisture, oxygen, and dust particles. The encapsulation layer TFE may seal the light emitting elements of the display layer DP-ED. The encapsulation layer TFE may include at least one thin film for improving optical efficiency of the display layer DP-ED, or protecting the display layer DP-ED.

The input sensor ISP may be disposed on the display panel DP. The input sensor ISP may sense an external input applied from the outside. The external input may be a user input. The user input may include various forms of external inputs, such as a part of a user's body, light, heat, a pen, pressure, or the like. The input sensor ISP may sense an external input and provide an input signal including information on the external input to enable the display panel DP to generate an image IM corresponding to the external input. The input sensor ISP may be driven in various manners, such as a capacitive manner, a resistive film manner, an infrared light manner, a sonic manner, or a pressure manner, but is not limited to any one thereof. In the embodiment, the input sensor ISP is described as being driven in a capacitive manner.

The input sensor ISP may be formed on the display panel DP through a continuous process. The input sensor ISP may be described as being directly disposed on the display panel DP. Being directly disposed may mean that a third element is not disposed between the input sensor ISP and the display panel DP. For example, a separate adhesive member may not be disposed between the input sensor ISP and the display panel DP.

The optical layer AF may be disposed on the input sensor ISP. The optical layer AF may be a reflection reduction layer which reduces reflectance by external light incident from the outside of the display module DM. The optical layer AF may be formed on the input sensor ISP through a continuous process. For example, the optical layer AF may include a polarizing film including a phase retarder and/or a polarizer, multi-layered reflection layers destructively interfere with reflected light, or color filters disposed corresponding to the pixel arrangement and emission colors of the display panel DP. For example, in case that the optical layer AF includes the color filters, the color filters may be arranged in consideration of emission colors of the pixels included in the display panel DP. In an embodiment, the optical layer AF may be omitted.

FIG. 4 is a schematic plan view of the display panel DP according to an embodiment. Referring to FIG. 4, in the display panel DP, a display region DA and a non-display region NDA around the display region DA may be defined. The display region DA and the non-display region NDA may be distinguished by whether there are pixels PX disposed therein or not. The pixels PX may be disposed in the display region DA, and the pixels PX may not be disposed in the non-display region NDA. In the non-display region NDA, a scan driver SDV, a data driver, and a light emission driver EDV may be disposed. The data driver may be a part of a circuit configured in the driving chip DIC.

The display panel DP may include the pixels PX, initialization scan lines GIL1 to GILm, compensation scan lines GCL1 to GCLm, write scan lines GWL1 to GWLm, and black scan lines GBL1 to GBLm, light emission control lines ECL1 to ECLm, data lines DL1 to DLn, first and second control lines CSL1, CSL2, a driving voltage line PL, the scan driver SDV, the data driver, the light emission driver EDV, the driving chip DIC, and the pads PD. Here, m and n may be natural numbers of 2 or greater. The data driver may be a part of a circuit configured in the driving chip DIC.

The pixels PX may be connected to the initialization scan lines GIL1 to GILm, the compensation scan lines GCL1 to GCLm, the write scan lines GWL1 to GWLm, the black scan lines GBL1 to GBLm, the light emission control lines ECL1 to ECLm, and the data lines DL1 to DLn.

The initialization scan lines GIL1 to GILm, the compensation scan lines GCL1 to GCLm, the write scan lines GWL1 to GWLm, and the black scan lines GBL1 to GBLm may be extended in the first direction DR1 to be electrically connected to the scan driver SDV. The data lines DL1 to DLn may be extended in the second direction DR2 to be electrically connected to the driving chip DIC. The light emission control lines ECL1 to ECLm may be extended in the first direction DR1 to be electrically connected to the light emission driver EDV.

The driving voltage line PL may include a portion extended in the first direction DR1 and a portion extended in the second direction DR2. The portion extended in the first direction DR1 and the portion extended in the second direction DR2 may be disposed on different layers. The driving voltage line PL may provide a driving voltage to the pixels PX.

A first control line CSL1 may be connected to the scan driver SDV. A second control line CSL2 may be connected to the light emission driver EDV.

The driving chip DIC, the driving voltage line PL, the first control line CSL1, and the second control line CSL2 may be electrically connected to the pads PD. The flexible circuit film FCB may be electrically connected to the pads PD through an anisotropic conductive adhesive layer. The pads PD may be pads for connecting the flexible circuit film FCB to the display panel DP. The pads PD may be connected to corresponding pixels PX via the driving voltage line PL, the first control line CSL1, and the second control line CSL2.

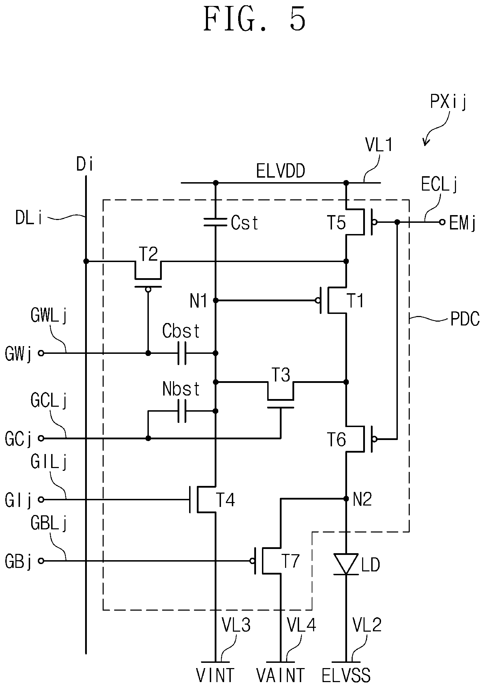

FIG. 5 is a schematic diagram of an equivalent circuit of a pixel PXij according to an embodiment.

FIG. 5 illustrates an equivalent circuit of a pixel PXij among pixels PX (see FIG. 4). Since each of the pixels PX may have the same circuit structure, with the provision of the description of the circuit structure for the pixel PXij, a detailed description of the rest of the pixels PX will be omitted.

Referring to FIG. 4 and FIG. 5, the pixel PXij may be connected to an i-th data line DLi among the data lines DL1 to DLn, a j-th initialization scan line GILj among the initialization scan lines GIL1 to GILm, a j-th compensation scan line GCLj among the compensation scan lines GCL1 to GCLm, a j-th write scan line GWLj among the write scan lines GWL1 to GWLm, a j-th black scan line GBLj among the black scan lines GBL1 to GBLm, a j-th light emission control line ECLj among the light emission control lines ECL1 to ECLm, first and second driving voltage lines VL1 and VL2, and first and second initialization voltage lines VL3 and VL4. Herein, i may be an integer of 1 to n, and j may be an integer of 1 to m.

The pixel PXij may include a light emitting element LD and a pixel circuit PDC. The light emitting element LD may be a light emitting diode. As an example, the light emitting element LD may be an organic light emitting diode including an organic light emitting layer, but embodiments are not limited thereto. The pixel circuit PDC may control the amount of current flowing through the light emitting element LD in response to a data signal Di. The light emitting element LD may emit light to a predetermined or selected luminance in correspondence to the amount of current provided from the pixel circuit PDC.

The pixel circuit PDC may include first to seventh transistors T1, T2, T3, T4, T5, T6, and T7, and first to third capacitors Cst, Cbst, and Nbst. However, the configuration of the pixel circuit PDC is not limited to the embodiment illustrated in FIG. 5. The pixel circuit PDC illustrated in FIG. 5 is only one example, and the configuration of the pixel circuit PDC may be modified and implemented.

At least one of the first to seventh transistors T1, T2, T3, T4, T5, T6, and T7 may be a transistor including a polysilicon layer. In an embodiment, at least one of the first to seventh transistors T1, T2, T3, T4, T5, T6, and T7 may be manufactured by a method for manufacturing a transistor of an embodiment, and at least one of the first to seventh transistors T1, T2, T3, T4, T5, T6, and T7 may include a polysilicon layer containing argon (Ar).

At least one of the first to seventh transistors T1, T2, T3, T4, T5, T6, and T7 may be a transistor having a low-temperature polycrystalline silicon (LTPS) semiconductor layer. The polysilicon layer may be crystallized by providing an excimer laser to an amorphous silicon layer.

At least one of the first to seventh transistors T1, T2, T3, T4, T5, T6, and T7 may be a transistor having an oxide semiconductor layer. For example, the third and fourth transistors T3 and T4 are oxide semiconductor transistors, and the first, second, fifth, sixth, and seventh transistors T1, T2, T5, T6, and T7 may be LTPS transistors.

Specifically, the first transistor T1 which directly affects the brightness of the light emitting element LD may be configured to include a semiconductor layer made of polysilicon (which may be referred to as polycrystalline silicon) having high reliability, through which a high-resolution display device may be implemented. Since an oxide semiconductor has high carrier mobility and low leakage current, a voltage drop is not large even in case that driving time is long. For example, since there is no significant change in the color of an image due to a voltage drop even during low-frequency driving, low-frequency driving is possible. Since the oxide semiconductor has the advantage of low leakage current as described above, at least one of the third transistor T3 and the fourth transistor T4 which are connected to a gate electrode of the first transistor T1 may be employed as an oxide semiconductor to prevent leakage current which may flow into the gate electrode and at the same time, to reduce power consumption.

Some of the first to seventh transistors T1 to T7 may be P-type transistors, and others thereof may be N-type transistors. For example, the first, second, fifth, sixth, and seventh transistors T1, T2, T5, T6, and T7 may each be a P-type transistor, and the third and fourth transistors T3 and T4 may each be an N-type transistor.

The configuration of the pixel circuit PDC according to the disclosure is not limited to the embodiment illustrated in FIG. 5. The pixel circuit PDC illustrated in FIG. 5 is just one example, and the configuration of the pixel circuit PDC may be modified and implemented. For example, all of the first to seventh transistors T1 to T7 may be P-type transistors or N-type transistors. In another embodiment, the first, second, fifth, and sixth transistors T1, T2, T5, and T6 may each be a P-type transistor, and the third, fourth, and seventh transistors T3, T4, and T7 may each be an N-type transistor.

The j-th initialization scan line GILj, the j-th compensation scan line GCLj, the j-th write scan line GWLj, the j-th black scan line GBLj, and the j-th light emission control line ECLj may respectively transmit an j-th initialization scan signal GIj, the j-th compensation scan signal GCj, the j-th write scan signal GWj, the j-th black scan signal GBj, and the j-th light emission control signal EMj to the pixel PXij. The i-th data line DLi transmits an i-th data signal Di to the pixel PXij. The i-th data signal Di may have a voltage level corresponding to an image signal input to the display device ELD (see FIG. 1).

The first and second driving voltage lines VL1 and VL2 may respectively transmit a first driving voltage ELVDD and a second driving voltage ELVSS to the pixel PXij. The first and second initialization voltage lines VL3 and VL4 may respectively transmit a first initialization voltage VINT and a second initialization voltage VAINT to the pixel PXij.

The first transistor T1 may be connected between the first driving voltage line VL1 receiving the first driving voltage ELVDD and the light emitting element LD. The first transistor T1 may include a first electrode connected to the first driving voltage line VL1 via the fifth transistor T5, a second electrode connected to a pixel electrode (or, referred to as an anode) of the light emitting element LD via the sixth transistor T6, and a third electrode (e.g., a gate electrode) connected to an end (e.g., a first node N1) of the first capacitor Cst. The first transistor T1 may receive the data signal Di transmitted by the i-th data line DLi in accordance with a switching operation of the second transistor T2, and supply a driving current to the light emitting element LD.

The second transistor T2 may be connected between the i-th data line DLi and the first electrode of the first transistor T1. The second transistor T2 may include a first electrode connected to the i-th data line DLi, a second electrode connected to the first electrode of the first transistor T1, and a third electrode (e.g., a gate electrode) connected to the j-th write scan line GWLj. The second transistor T2 may be turned on in response to the j-th write scan signal GWj received through the j-th write scan line GWLj and transmit the i-th data signal Di transmitted from the i-th data line DLi to the first electrode of the first transistor T1. An end of the second capacitor Cbst may be connected to the third electrode of the second transistor T2, and another end of the second capacitor Cbst may be connected to the first node N1.

The third transistor T3 may be connected between the second electrode of the first transistor T1 and the first node N1. The third transistor T3 may include a first electrode connected to the third electrode of the first transistor T1, a second electrode connected to the second electrode of the first transistor T1, and a third electrode (e.g., a gate electrode) connected to the j-th compensation scan line GCLj. The third transistor T3 may be turned on in response to the j-th compensation scan signal GCj received through the j-the compensation scan line GCLj, and may diode-connect the first transistor T1 by connecting the third electrode of the first transistor T1 and the second electrode of the first transistor T1 to each other. An end of the third capacitor Nbst may be connected to the third electrode of the third transistor T3, and another end of the third capacitor Nbst may be connected to the first node N1.

The fourth transistor T4 may be connected between the first initialization voltage line VL3 to which the first initialization voltage VINT is applied and the first node N1. The fourth transistor T4 may include a first electrode connected to the first initialization voltage line VL3 to which the first initialization voltage VINT is transmitted, a second electrode connected to the first node N1, and a third electrode (e.g., a gate electrode) connected to the j-th initialization scan line GILj. The fourth transistor T4 may be turned on in response to the j-th initialization scan signal GIj received through the j-th initialization scan line GILj. The turned-on fourth transistor T4 may transmit the first initialization voltage VINT to the first node N1 and initializes the potential of the third electrode of the first transistor T1 (e.g., the potential of the first node N1).

The fifth transistor T5 may include a first electrode connected to the first driving voltage line VL1, a second electrode connected to the first electrode of the first transistor T1, and a third electrode (e.g., a gate electrode) connected to the j-th light emission control line ECLj. The sixth transistor T6 may include a first electrode connected to the second electrode of the first transistor T1, a second electrode connected to the pixel electrode of the light emitting element LD via second node N2, and a third electrode (e.g., a gate electrode) connected to the j-th light emission control line ECLj.

The fifth and sixth transistors T5 and T6 may be simultaneously turned on in response to the j-th light emission control signal EMj received through the j-th light emission control line ECLj. The first driving voltage ELVDD applied through the turned-on fifth transistor T5 may be compensated through the diode-connected first transistor T1 and transmitted to the light emitting element LD through the sixth transistor T6.

The seventh transistor T7 may include a first electrode connected to the second initialization voltage line VL4 to which the second initialization voltage VAINT is transmitted, a second electrode connected to the second electrode of the sixth transistor T6 via the second node N2, and a third electrode (e.g., a gate electrode) connected to the j-th black scan line GBLj. The second initialization voltage VAINT may have a voltage level lower than or equal to that of the first initialization voltage VINT.

An end of the first capacitor Cst may be connected to the third electrode of the first transistor T1, and another end of the first capacitor Cst may be connected to the first driving voltage line VL1. A cathode of the light emitting element LD may be connected to the second driving voltage line VL2 which transmits the second driving voltage ELVSS. The second driving voltage ELVSS may have a lower voltage level than the first driving voltage ELVDD.

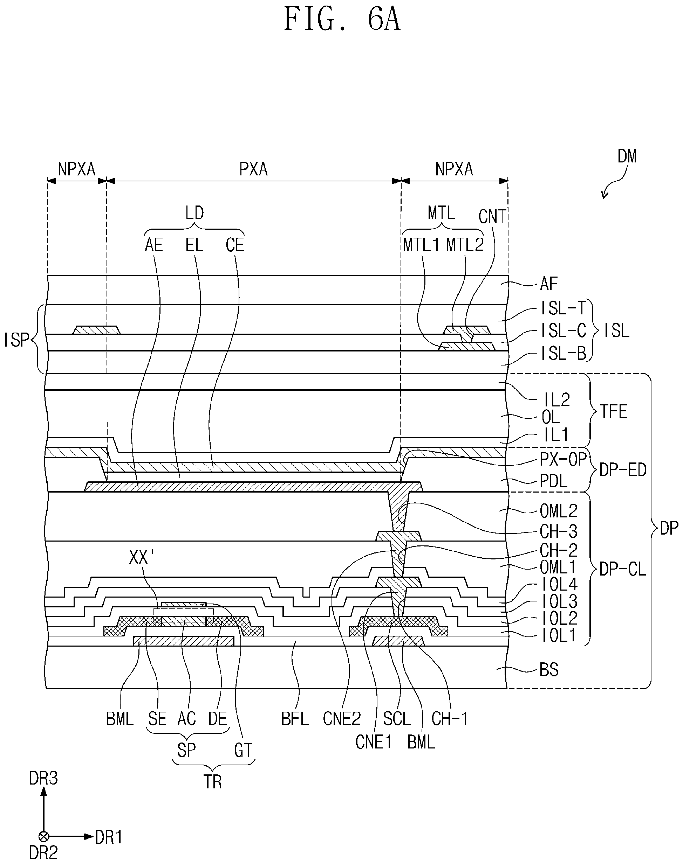

FIG. 6A is a schematic cross-sectional view of a portion of a display module according to an embodiment. FIG. 6A illustrates a cross-section of a light emitting region PXA and a non-light emitting region NPXA adjacent to the light emitting region PXA in a portion in which one pixel PX (see FIG. 4) is disposed.

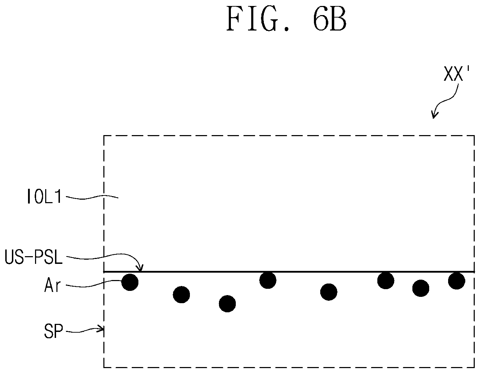

FIG. 6B is a schematic cross-sectional view showing a portion of a transistor according to an embodiment. FIG. 6B is a cross-sectional view showing enlarged region XX' of FIG. 6A.

The display module DM may include the display panel DP and the input sensor ISP, and the display panel DP may include the base layer BS, the circuit layer DP-CL, the display layer DP-ED, and the encapsulation layer TFE. The pixel PX (see FIG. 4) may have an equivalent circuit including transistors, a capacitor, and a light emitting element, and the equivalent circuit diagram of a pixel may be modified into various forms. In FIG. 6A, a transistor TR and a light emitting element LD included in the pixel PX (FIG. 4) are illustrated.

The display panel DP according to an embodiment may include insulation layers, transistors, a conductive pattern, a signal line, and the like.

Inorganic films, organic films, a semiconductor layer, and a conductive layer may be formed by coating, deposition, or the like. Thereafter, the inorganic films, the organic films, the semiconductor layer, and the conductive layer may be selectively patterned by photolithography. In this manner, the circuit layer DP-CL including the insulation layers respectively formed from the inorganic films and the organic films, the transistors including a semiconductor pattern formed from the semiconductor layer, and the conductive pattern and the signal line formed from the conductive layer may be formed.

Thereafter, the display layer DP-ED including the light emitting element LD which includes a conductive pattern and the like may be formed on the circuit layer DP-CL, and the encapsulation layer TFE which covers the display layer DP-ED may be formed.

Referring to FIG. 6A, the circuit layer DP-CL may include a shielding electrode BML, a buffer layer BFL, insulation layers IOL1, IOL2, IOL3, and IOL4 each including an inorganic film, insulation layers OML1 and OMI,2 each including an organic film, the transistor TR, connection electrodes CNE1 and CNE2, and a signal line SCL, and the like.

The shielding electrode BML may be disposed on the base layer BS. The shielding electrode BML may overlap the transistor TR. In an embodiment, the shielding electrode BML may also be disposed in a lower portion of the signal line SCL. The shielding electrode BML may block light incident from a lower portion of the display panel DP to the transistor TR or the signal line SCL so as to protect a semiconductor pattern or a conductive pattern such as the transistors TR and the signal line SCL. The shielding electrode BML may contain a conductive material. In an embodiment, the shielding electrode BML may be connected to a driving voltage line PL (FIG. 4) to be applied with a voltage. In case that the voltage is applied to the shielding electrode BML, a threshold voltage of the transistor TR disposed on the shielding electrode BML may be maintained. However, embodiments are not limited thereto, and the shielding electrode BML may be a floating electrode. In an embodiment, the shielding electrode BML may be omitted.

The buffer layer BFL may be disposed on the base layer to cover the shielding electrode BML. The buffer layer BFL may improve coupling force between a semiconductor pattern or conductive pattern disposed on the buffer layer BFL and the base layer BS. The buffer layer BFL may prevent the diffusion of metal atoms or impurities from the base layer BS into the semiconductor pattern or the conductive pattern.

The buffer layer BFL may be an inorganic film. The buffer layer BFL may include at least one of silicon oxide, silicon nitride, and silicon oxynitride. For example, the buffer layer BFL may include a structure in which a silicon oxide layer and a silicon nitride layer are alternately stacked on each other.

The transistor TR may include a source SE, a channel AC, a drain DE, and a gate GT. The source SE, the channel AC, and the drain DE of the transistor TR may constitute a semiconductor pattern SP.

In an embodiment, the semiconductor pattern SP of the transistor TR may include polycrystalline silicon(p-Si). The semiconductor pattern SP of the transistor TR may be a polysilicon layer including polycrystalline silicon. In an embodiment, the semiconductor pattern SP may be a polysilicon layer including crystals crystallized from amorphous silicon (may also be referred to as amorphous silicon(a-Si)). The source SE, the channel AC, the drain DE, and the like formed as the semiconductor pattern may be a polysilicon layer.

In an embodiment, the semiconductor pattern SP may include argon (Ar). Referring to FIG. 6B, the argon (Ar) may be included adjacent to an upper surface of the semiconductor pattern SP. For example, in an embodiment, the argon (Ar) may be included adjacent to a first insulation layer IOL1. However, embodiments are not limited thereto, and in an embodiment, the distribution of argon (Ar) included in the transistor TR may be random.

The source SE and the drain DE of the transistor TR may be extended in opposite directions from the channel AC on a cross-section. FIG. 6A illustrates a portion of the signal line SCL formed from a semiconductor pattern. Although not separately illustrated, the signal line SCL may be connected to the drain DE of the transistor TR.

The semiconductor pattern may include multiple regions distinguished according to the magnitude of conductivity. In the semiconductor pattern, a region doped with a dopant or a region in which a metal oxide is reduced may have high conductivity, and may substantially serve as a source electrode and a drain electrode of the transistor TR. In the semiconductor pattern, a region having high conductivity may correspond to the source SE and the drain DE of the transistor TR. A region which is not doped or doped to a low concentration, or has low conductivity due to non-reduction of a metal oxide may correspond to the channel AC (or an active) of the transistor TR.

The first insulation layer IOL1 may be disposed on the buffer layer BFL while covering the semiconductor pattern of the transistor TR. The first insulation layer IOL1 may be referred to as a gate insulation layer. The gate GT of the transistor TR may be disposed on the first insulation layer IOL1. The gate GT may overlap the semiconductor pattern SP with the first insulation layer IOL1, which is the gate insulation layer, disposed between the gate GT and the semiconductor pattern SP. The gate GT may overlap the channel AC of the transistor TR. In an embodiment, the gate GT may serve as a mask in a process of doping the semiconductor pattern of the transistor TR.

The gate GT may include, but is not particularly limited to, titanium (Ti), silver (Ag), a silver-containing alloy, molybdenum (Mo), a molybdenum-containing alloy, aluminum (Al), an aluminum-containing alloy, an aluminum nitride (AlN), tungsten (W), tungsten nitride (WN), copper (Cu), indium tin oxide (ITO), indium zinc oxide (IZO), or the like.

The first insulation layer IOL1 may include an inorganic film. The first insulation layer IOL1 may also be referred to as a first inorganic film. For example, the first insulation layer IOL1 may be an inorganic film including at least one of aluminum oxide, titanium oxide, silicon oxide, silicon nitride, silicon oxynitride, zirconium oxide, and hafnium oxide. The first insulation layer IOL1 may have a single-layered or multi-layered structure. The first insulation layer IOL1 may have a structure in which inorganic films are stacked on each other.

In an embodiment, the first insulation layer IOL1 may further include an organic film in addition to the inorganic film. In case that the first insulation layer IOL1 includes a structure in which the inorganic film and the organic film are stacked on each other, the first insulation layer IOL1 may further include a buffer inorganic film disposed between the inorganic film and the organic film adjacent to each other.

The multi-layered structure described with reference to the first insulation layer IOL1 may also be introduced in a second insulation layer to a fourth insulation layer IOL2, IOL3, and IOL4 to be described below. Accordingly, the stacking structure of insulation layers of the above-described multi-layered structure, the configuration of the buffer inorganic film in the multi-layered structure, and the like may be equally applied to the second insulation layer to the fourth insulation layer IOL2, IOL3, and IOL4.

The second insulation layer IOL2 may be disposed on the first insulation layer IOL1, and may cover the gate GT. The second insulation layer IOL2 may commonly overlap pixels. The second insulation layer IOL2 may include an inorganic film. The second insulation layer IOL2 may also be referred to as a second inorganic film. For example, the second insulation layer IOL2 may include at least one of silicon oxide, silicon nitride, and silicon oxynitride. The second insulation layer IOL2 may be an inorganic layer and/or an organic layer, and may have a single-layered or multi-layered structure. In an embodiment, the second insulation layer IOL2 may have a multi-layered structure including a silicon oxide layer and a silicon nitride layer.

The third insulation layer IOL3 may be disposed on the second insulation layer IOL2. The third insulation layer IOL3 may include an inorganic film. The third insulation layer IOL3 may also be referred to as a third inorganic film. The third insulation layer IOL3 may have a single-layered or multi-layered structure. For example, the third insulation layer IOL3 may have a multi-layered structure including a silicon oxide layer and a silicon nitride layer.

A first connection electrode CNE1 may be disposed on the third insulation layer IOL3. The first connection electrode CNE1 may be connected to the signal line SCL via a first contact-hole CH-1 passing through the first, second, and third insulation layers IOL1, IOL2, and IOL3.

The fourth insulation layer IOL4 may be disposed on the third insulation layer IOL3. The fourth insulation layer IOL4 may include an inorganic film, and the fourth insulation layer IOL4 may also be referred to as a fourth inorganic film. The fourth insulation layer IOL4 may be a single-layered silicon oxide layer.

The fifth insulation layer OML1 may be disposed on the fourth insulation layer IOL4. The fifth insulation layer OML1 may include an organic film. The fifth insulation layer OML1 may be referred to as a first organic film. The first organic film may include at least one of an acrylic resin, a methacrylic resin, polyisoprene, a vinyl-based resin, an epoxy-based resin, a urethane-based resin, a cellulose-based resin, a siloxane-based resin, a polyamide-based resin, and a perylene-based resin.

A second connection electrode CNE2 may be disposed on the fifth insulation layer OMI,1. The second connection electrode CNE2 may be connected to the first connection electrode CNE1 via a second contact hole CH-2 passing through the fourth insulation layer IOL4 and the fifth insulation layer OMI,1.

The sixth insulation layer OMI,2 may be disposed on the fifth insulation layer OML1, and may cover the second connection electrode CNE2. The sixth insulation layer OMI,2 may include an organic film. The sixth insulation layer OMI,2 may be referred to as a second organic film. The second organic film may include at least one of an acrylic resin, a methacrylic resin, polyisoprene, a vinyl-based resin, an epoxy-based resin, a urethane-based resin, a cellulose-based resin, a siloxane-based resin, a polyamide-based resin, and a perylene-based resin.

Although not illustrated in FIG. 6A, a circuit layer may further include transistors, and may further include signal lines electrically connected to the transistors. The signal lines may be extended and connected to the pads PD of the non-display region NDA (see FIG. 4).

The display layer DP-ED may be disposed on the circuit layer DP-CL. The display layer DP-ED may include a pixel definition layer PDL and a light emitting element LD. The light emitting element LD may include a first electrode AE, a light emitting layer EL, and a second electrode CE.

The first electrode AE may be disposed on the sixth insulation layer OMI,2. The first electrode AE may be connected to the second connection electrode CNE2 via a third contact-hole CH-3 passing through the sixth insulation layer OMI,2. The first electrode AE may be electrically connected to the drain DE of the transistor TR via the first and second connection electrodes CNE1 and CNE2.

The first electrode AE may be referred to as a pixel electrode. The first electrode AE may be formed of a metal material, a metal alloy, or a conductive compound. The first electrode AE may be an anode or a cathode. The first electrode AE may be a transmissive electrode, a transflective electrode, or a reflective electrode. In case that the first electrode AE is a transmissive electrode, the first electrode AE may include a transparent metal oxide, for example, indium tin oxide (ITO), indium zinc oxide (IZO), zinc oxide (ZnO), indium tin zinc oxide (ITZO), or the like. In case that the first electrode AE is a transflective electrode or a reflective electrode, the first electrode AE may include Ag, Mg, Cu, Al, Pt, Pd, Au, Ni, Nd, Ir, Cr, Li, Ca, LiF/Ca, LiF/Al, Mo, Ti, W, or a compound or mixture thereof (e.g., a mixture of Ag and Mg). In another embodiment, the first electrode AE may have a multi-layered structure including a reflective film or transflective film formed of the above materials, and a transparent conductive film formed of indium tin oxide (ITO), indium zinc oxide (IZO), zinc oxide (ZnO), indium tin zinc oxide (ITZO), or the like. For example, the first electrode AE may have a three-layered structure of ITO/Ag/ITO. Embodiments are not limited thereto, and the first electrode AE may include any one of the above-described metal materials, a combination of two or more selected from the above-described metal materials, an oxide of any one of the above-described metal materials, or the like.

The pixel definition layer PDL may be disposed on the sixth insulation layer OML2. In an embodiment, the pixel definition layer PDL may be formed of a polymer resin. For example, the pixel definition layer PDL may be formed by including a polyacrylate-based resin or a polyimide-based resin. The pixel definition layer PDL may be formed by further including an inorganic substance in addition to the polymer resin. The pixel definition layer PDL may be formed by including a light absorbing material, or may be formed by including a black pigment or a black dye. The pixel definition layer PDL formed by including a black pigment or a black dye may implement a black pixel definition layer. In case that the pixel definition layer PDL is formed, carbon black and the like may be used as a black pigment or a black dye, but embodiments are not limited thereto.

The pixel definition layer PDL may be formed of an inorganic substance. For example, the pixel definition layer PDL may be formed by including silicon nitride, silicon oxide, silicon oxynitride, or the like.

On the pixel definition layer PDL, a pixel opening PX-OP which exposes a portion of the first electrode AE may be defined. In the display module DM of an embodiment, light emitting regions PXA may be distinguished by the pixel definition layer PDL. The display module DM may include the light emitting regions PXA and a non-light emitting region NPXA, and the non-light emitting region NPXA may be a portion overlapping the pixel definition layer PDL. In the pixel opening PX-OP, a portion corresponding to the exposed first electrode AE may be defined as the light emitting region PXA.

In the light emitting element LD, the light emitting layer EL may be disposed on the first electrode AE. In the embodiment, the light emitting layer EL may emit light of at least one color of blue, red, and green. In an embodiment, the light emitting layer EL may provide blue light throughout the display region DA (see FIG. 4).

The second electrode CE may be disposed on the light emitting layer EL. The second electrode CE may have a shape of a single body, and may be commonly disposed in the pixels PX (see FIG. 4). The second electrode CE may be referred to as a common electrode. The second electrode CE may be a cathode or an anode. For example, in case that the first electrode AE is an anode, the second electrode CE may be a cathode, and in case that the first electrode AE is a cathode, the second electrode CE may be an anode.

The second electrode CE may be a transmissive electrode, a transflective electrode, or a reflective electrode. In case that the second electrode CE is a transmissive electrode, the second electrode CE may be formed of a transparent metal oxide, for example, indium tin oxide (ITO), indium zinc oxide (IZO), zinc oxide (ZnO), indium tin zinc oxide (ITZO), or the like. The second electrode CE may be formed by including Ag, Mg, Cu, Al, Pt, Pd, Au, Ni, Nd, Ir, Cr, Li, Ca, LiF/Ca, LiF/Al, Mo, Ti, W, or a compound or mixture thereof (e.g., a mixture of Ag and Mg).

Although not illustrated, a hole control layer may be disposed between the first electrode AE and the light emitting layer EL. The hole control layer may include a hole transport layer, and may further include a hole injection layer. An electron control layer may be disposed between the light emitting layer EL and the second electrode CE. The electron control layer may include an electron transport layer, and may further include an electron injection layer. The hole control layer and the electron control layer may be commonly formed in the pixels PX (see FIG. 4) using an open mask.

The encapsulation layer TFE may be disposed on the display layer DP-ED. The encapsulation layer TFE may include a first inorganic layer IL1, an organic layer OL, and a second inorganic layer IL2, which are stacked on each other. However, layers constituting the encapsulation layer TFE are not limited thereto.

The inorganic layers IL1 and IL2 may protect the display layer DP-ED from moisture and oxygen, and the organic layer OL may protect the display layer DP-ED from foreign substances such as dust particles. The inorganic layers IL1 and IL2 may include at least one of silicon nitride, silicon oxynitride, silicon oxide, titanium oxide, and aluminum oxide. The organic layer OL may include an acrylic organic material. However, the types of materials constituting the inorganic layers IL1 and IL2 and the organic layer OL are not limited thereto.

The input sensor ISP may be disposed on the encapsulation layer TFE. In an embodiment, the input sensor ISP may include a sensor insulation layer ISL and sensor conductive layers MTL. The sensor insulation layer ISL may include a sensor base layer ISL-B and interlayer insulation layers ISL-C and ISL-T.

In FIG. 6A, the input sensor ISP is illustrated in a multi-layered structure including a first sensor conductive layer MTL1 and a second sensor conductive layer MTL2. The second sensor conductive layer MTL2 may be connected to the first sensor conductive layer MTL1 via a contact-hole CNT. However, embodiments are not limited thereto, and the input sensor ISP may include a sensor conductive layer of a single layer. At least one of the interlayer insulation layers ISL-C and ISL-T may be omitted.

In an embodiment, the sensor base layer ISL-B may be directly disposed on the encapsulation layer TFE. For example, the sensor base layer ISL-B may be directly disposed on the second inorganic layer IL2 of the encapsulation layer TFE.

Referring to FIG. 6A, the display module DM according to an embodiment may include the optical layer AF. In an embodiment, the optical layer AF may be directly disposed on the interlayer insulation layer ISL-T. However, embodiments are not limited thereto, and an adhesive layer and the like may be further included between the optical layer AF and the input sensor ISP. The optical layer AF may be a reflection reduction layer which reduces external light. In an embodiment, the optical layer AF may be omitted.

The transistor TR included in the above-described display module DM may be manufactured by the method for manufacturing a transistor of an embodiment. The transistor TR manufactured by the method for manufacturing a transistor according to an embodiment exhibits excellent mobility and reliability properties, and the reliability and display quality of a display device according to an embodiment including the transistor may be improved.

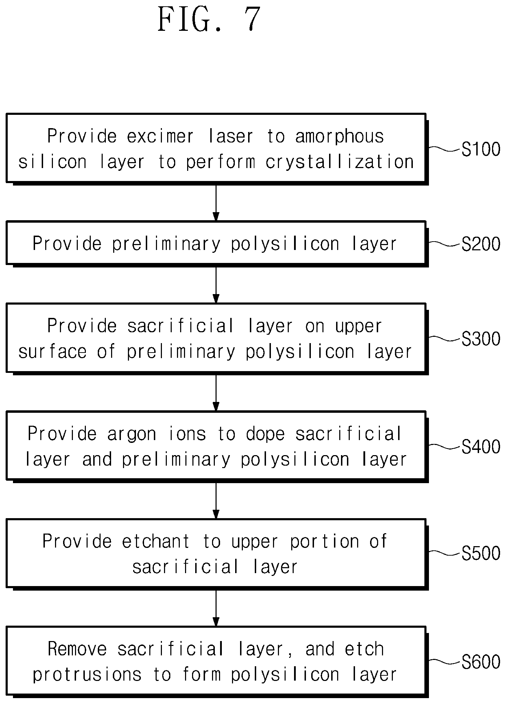

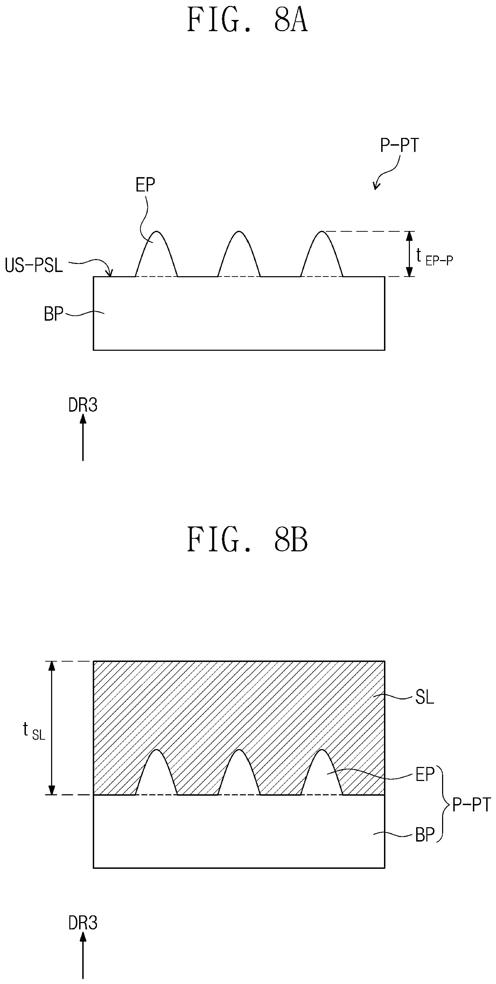

FIG. 7 is a flowchart of a method for manufacturing a transistor according to an embodiment. FIG. 8A to FIG. 8G are each a schematic drawing showing an operation of the method for manufacturing a transistor according to an embodiment.

Referring to FIG. 7 to FIG. 8G and the like, the method for manufacturing a transistor of an embodiment may include providing a preliminary polysilicon layer S200, providing a sacrificial layer on an upper surface of the preliminary polysilicon layer S300, providing argon (Ar) ions to dope the sacrificial layer and the preliminary polysilicon layer S400, providing an etchant to an upper portion of the sacrificial layer S500, and removing the sacrificial layer, and etching protrusions to form a polysilicon layer S600. The preliminary polysilicon layer may be formed in an operation of performing crystallization by providing an excimer laser to an amorphous silicon layer. Therefore, the method for manufacturing a transistor of an embodiment may include the operation of performing crystallization by providing an excimer laser to an amorphous silicon layer S 100 before the operation of providing a preliminary polysilicon layer S200.

The operation of performing crystallization by providing an excimer laser to an amorphous silicon layer S100 may correspond to an excimer laser annealing (ELA) process operation. Amorphous silicon may be crystallized by heat provided from laser energy in the ELA process operation.

In the specification, the preliminary polysilicon layer may include polycrystalline silicon, and refers to the state of the layer after the amorphous silicon layer is crystallized. The preliminary polysilicon layer is described distinguished from the polysilicon layer, and the preliminary polysilicon layer may correspond to the polysilicon layer before the operation of providing the etchant, and may be different in surface properties from the polysilicon layer formed by surface treatment with the etchant. For example, in the specification, the preliminary polysilicon layer may refer to the state before the protrusions on the surface are etched. The preliminary polysilicon layer and the polysilicon layer may have the same crystallization properties, other physical properties, and the like.

In FIG. 8A, the operation of providing a preliminary polysilicon layer P-PT S200 is illustrated. Protrusions EP may be disposed on an upper surface US-PSL of the preliminary polysilicon layer P-PT. The protrusions EP may be portions formed by protruding from the upper surface US-PSL. In the preliminary polysilicon layer P-PT, a base portion BP may be a silicon layer including crystals.

In FIG. 8A, and the like, the protrusions EP are illustrated as being formed in a similar shape and a similar size, and arranged at regular intervals, but embodiments are not limited thereto. The protrusions EP may each have a random shape, a random size, and random disposition properties. The protrusions EP may be generated in the crystallization operation S 100. The protrusions EP may be generated during a phase change operation of silicon in the operation of performing crystallization by providing an excimer laser to the amorphous silicon layer. For example, the protrusions EP may be generated in portions corresponding to the boundaries between formed crystals.

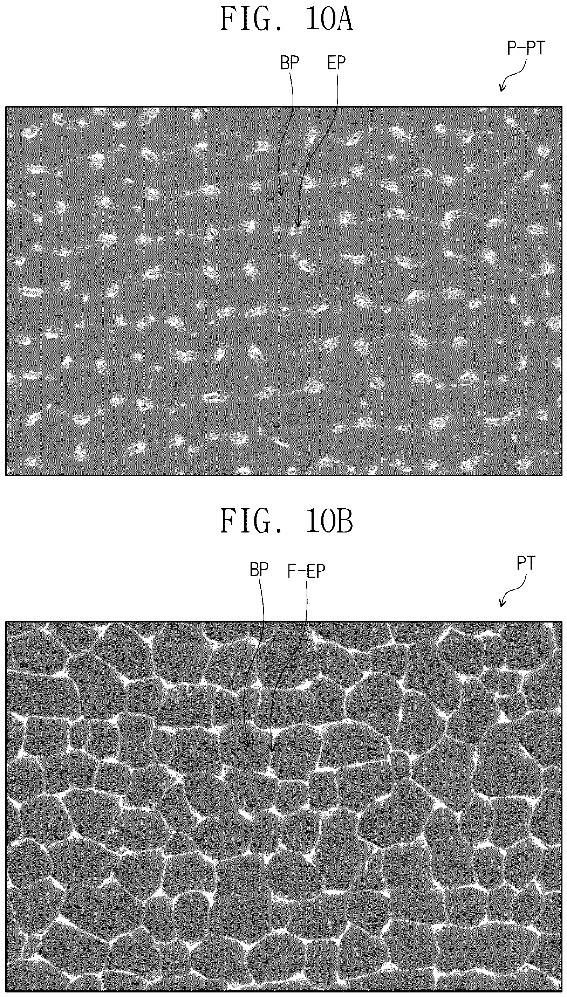

FIG. 10A is a schematic view showing a planar image of a preliminary polysilicon layer according to an embodiment. FIG. 10A shows an image of the preliminary polysilicon layer P-PT taken with a scanning electron microscope (SEM). In the image of FIG. 10A, relatively bright portions may correspond to the protrusions EP, and relatively dark and planar portions may correspond to the base portions BP. For example, FIG. 10A may correspond to a planar image of the preliminary polysilicon layer P-PT illustrated in FIG. 8A.

Referring to the image of FIG. 10A, the protrusion EP may be randomly generated, and may be formed at the boundaries between crystals forming the base portion BP, which may correspond to a relatively flat plane.

The protrusions EP formed by protrusion may degrade the properties of a transistor and the like including a polysilicon layer. The surface of the polysilicon layer becomes not uniform due to the protrusions EP, which results in an increase in surface roughness, and accordingly, there may be problems in that the reliability of the transistor formed by including the polysilicon layer may be degraded, and electrical properties such as low-frequency properties may be degraded. Accordingly, it is desirable to effectively remove the protrusions EP while minimizing the influence on the base portion BP.

FIG. 8B is a view showing the operation of providing a sacrificial layer on an upper surface of the preliminary polysilicon layer S300. A sacrificial layer SL may be provided on the preliminary polysilicon layer P-PT on which the protrusion EP is formed.

The sacrificial layer SL may include silicon oxide(SiOx). For example, the sacrificial layer SL may be formed by including silicon dioxide(SiO₂).

The sacrificial layer SL may be provided with a thickness sufficient to cover the protrusions EP. An average thickness t_{SL} of the sacrificial layer SL may be about 300 Å to about 1000 Å. For example, the average thickness t_{SL} of the sacrificial layer SL may be about 500 Å or greater. The average thickness may correspond to an average value of the thickness of the sacrificial layer SL provided on the base portion BP of the preliminary polysilicon layer P-PT and the thickness of the entire sacrificial layer SL provided on the protrusions EP.

In case that the average thickness t_{SL} of the sacrificial layer SL is less than 300 Å, the coating uniformity of the sacrificial layer SL may not be secured, so that the etching quality may be degraded during the subsequent etching process using an etchant. In case that the average thickness t_{SL} of the sacrificial layer SL is greater than 1000 Å, there may be a problem of degradation in processability, such as an increase in track time.

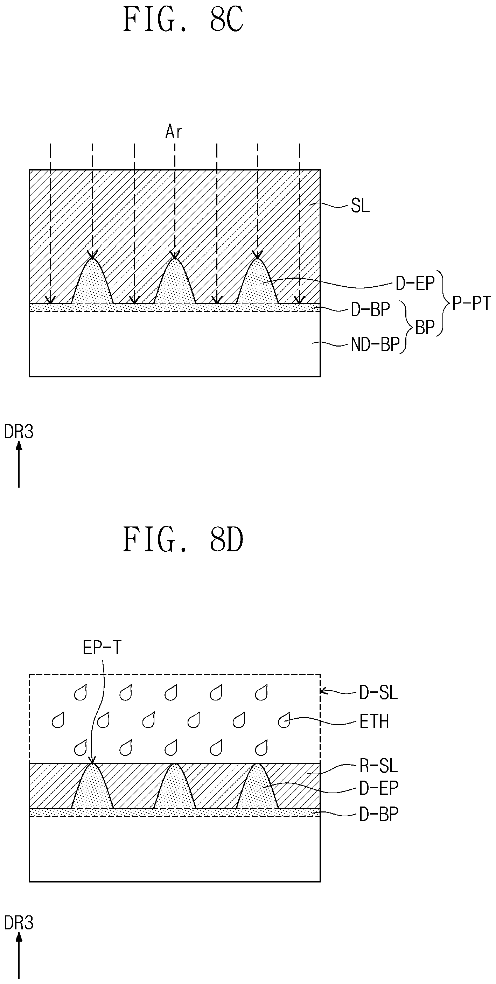

FIG. 8C is a view showing the operation of providing argon ions to dope the sacrificial layer and the preliminary polysilicon layer S400. The argon (Ar) ions may be provided from an upper portion of the sacrificial layer SL. The sacrificial layer SL and the preliminary polysilicon layer P-PT may be doped by the provided argon (Ar) ions. In the preliminary polysilicon layer P-PT, the protrusion EP (see FIG. 8B) portion may be doped. Argon is an inert ion, which may minimize the change in the properties of a doped element even after doping.

The doping operation S400 may be performed using an ion implantation facility. The doping operation S400 may include providing argon ions by optimizing the acceleration voltage and the dose amount in the ion implantation facility. The acceleration voltage and the dose amount corresponding to doping conditions may vary depending on the thickness of provided sacrificial layer SL, the thickness of generated protrusions EP, and the like.

In an embodiment, in case that the sacrificial layer SL is provided to a thickness of about 300 Å to about 1000 Å, argon ions may be provided to the preliminary polysilicon layer P-PT with an acceleration voltage of about 5 keV to about 80 keV, and a dose amount of about 1.0E15 to about 1.0E20 using an ion implantation facility in the doping operation S400.

Argon has a relatively large atomic weight among inert ions, so that in case argon ions are used as compared to a case of doping with ions having a relatively small atomic weight, damage may be propagated in a region adjacent to a provided surface. Accordingly, in the case of argon ions, shallow doping may occur in which doping is achieved in a region adjacent to the surface, or in a protruding portion.

The atomic weight of argon is about 38, and compared to performing doping using, for example, boron (B) (the atomic weight thereof is about 10.8) or phosphorus (P) (the atomic weight thereof is about 30.9) which has a smaller atomic weight than argon, argon doping facilitates energy transfer in a lateral direction in a region closer to a surface, or a region adjacent to a portion in which provided ions reach.

Accordingly, argon (Ar) may be doped on the sacrificial layer SL and the protrusions EP of the preliminary polysilicon layer P-PT. Argon may be doped in a portion adjacent to the upper surface of the base portion BP of the preliminary polysilicon layer P-PT.

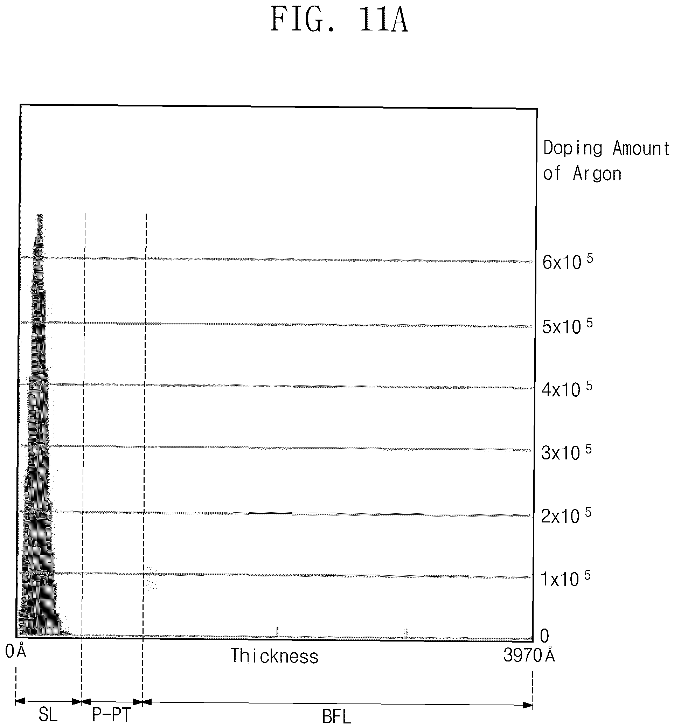

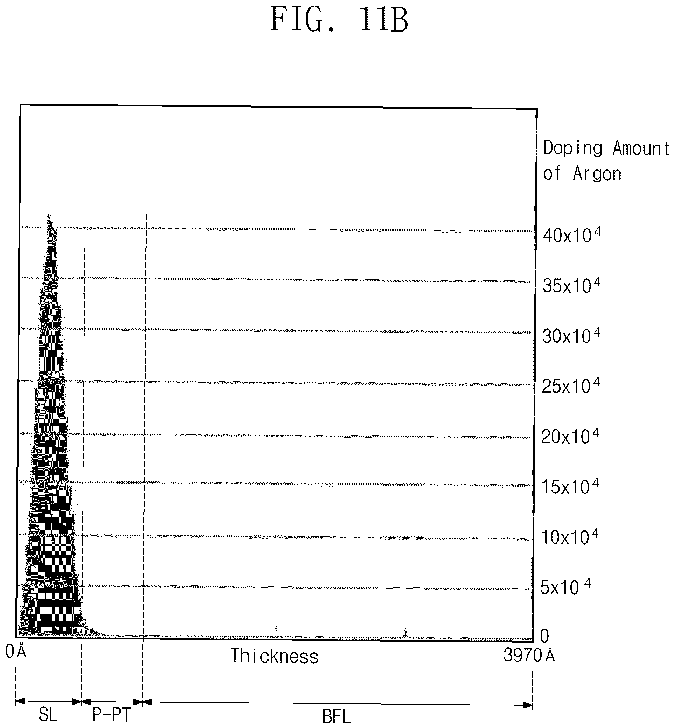

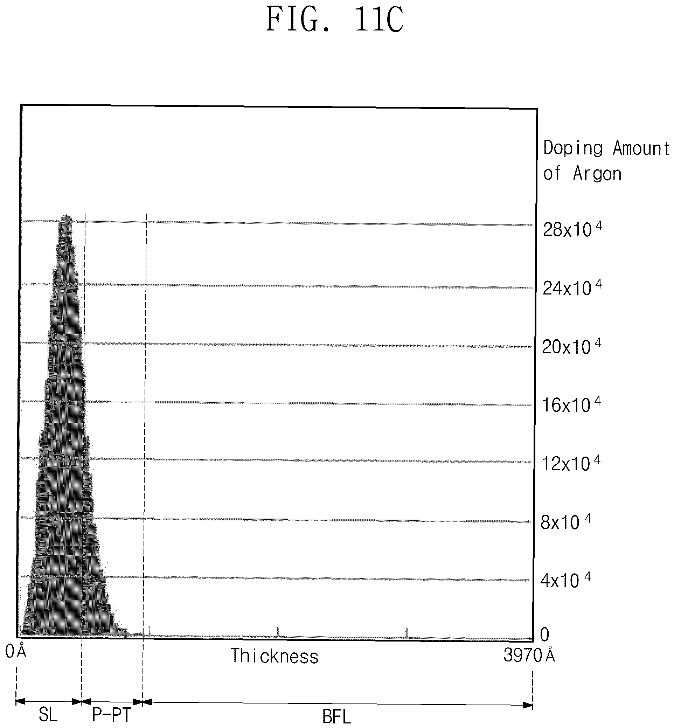

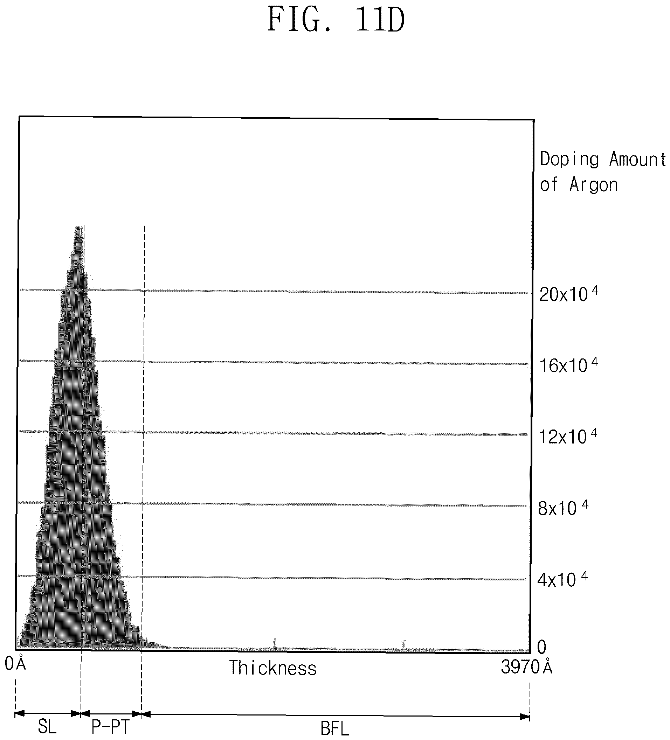

FIG. 11A to FIG. 11D are each a schematic view showing simulation results for argon doping according to an embodiment. The simulation results illustrated in FIG. 11A to FIG. 11D are results derived using a simulation program called Stopping and Range of Ions in Materials (SRIM).

FIG. 11A to FIG. 11D are respectively results that may be derived by varying an acceleration voltage. FIG. 11A to FIG. 11D are respectively results of simulation that may be performed by adjusting the acceleration voltage to 10keV, 20keV, 30keV, and 40keV. In the simulation, a silicon dioxide layer of 500 Å may be used as the sacrificial layer SL (see FIG. 8C).

Peaks in the graphs illustrated in FIG. 11A to FIG. 11D may correspond to a doping amount of argon. In FIG. 11A to FIG. 11D, the doping amount of argon according to a thickness may be shown. FIG. 11A to FIG. 11D may correspond to ones showing the doping amount of argon according to an increase in thickness in a stacked structure of the preliminary polysilicon layer P-PT and the buffer layer BFL, which is disposed in a downward direction with respect to an upper surface (0 Å) of the sacrificial layer SL. The buffer layer BFL which is indicated as a distinct region in FIG. 11A to FIG. 11D may correspond to the buffer layer of FIG. 6A.

Referring to FIG. 11A to FIG. 11D, it can be seen that the doping amount of argon may increase as the acceleration voltage increases, and as the acceleration voltage increases, argon may be doped deeper in a thickness direction from the surface. For example, in case that the thickness of the sacrificial layer SL is about 500 Å, and the acceleration voltage is about 20 keV or greater, argon may be doped on the preliminary polysilicon layer P-PT. Referring to FIG. 11A to FIG. 11D, in case that the thickness of the sacrificial layer SL is about 500 Å, and the acceleration voltage is about 20 keV to about 40 keV, the preliminary polysilicon layer P-PT may be sufficiently doped. Particularly, in case that the acceleration voltage is about 30 keV, the doping amount may increase on the upper surface of the preliminary polysilicon layer P-PT.

For example, it can be seen from the simulation results of FIG. 11A to FIG. 11D that argon doping process conditions should be adjusted according to the thickness of a sacrificial layer SL. For example, the acceleration voltage may be controlled during argon doping according to the thickness of the sacrificial layer SL to effectively dope the upper surface of the preliminary polysilicon layer.

In FIG. 8C, the preliminary polysilicon layer P-PT is illustrated as including doped protrusions D-EP and a doped base portion D-BP, and including a non-doped base portion ND-BP on a lower side of the doped base portion D-BP. However, this is only an example, and embodiments of the disclosure are not limited thereto. Argon may also be doped in the non-doped base portion ND-BP indicated as a distinct region, and a portion of a non-doped region may also be included in a portion indicated as the doped base portion D-BP.

FIG. 8D shows an example after the operation of providing an etchant to an upper portion of the sacrificial layer S500. An etchant ETH may be provided to the upper part of the sacrificial layer SL (see FIG. 8C) after doping.

In an embodiment, the etchant ETH may be an acidic solution. The etchant ETH may be a Buffer Oxide Etchant (BOE). In an embodiment, the etchant ETH may contain hydrogen fluoride (HF) and ammonium fluoride (NH₄F). HF and NH₄F may be diluted and used.

A portion of the sacrificial layer SL and a portion of the preliminary polysilicon layer P-PT may be etched by the etchant ETH. In an embodiment, the sacrificial layer SL doped with argon and the doped protrusions D-EP may be etched by the etchant ETH.

Polysilicon doped with argon may have an increased etch rate compared to undoped polysilicon. Silicon oxide or the like used as a sacrificial layer may also have an increased etch rate during argon doping.

The rate of increase in etch rate due to argon doping may be greater in the case of polysilicon than in the case of silicon oxide. For example, in case that a silicon oxide layer and a polysilicon layer are equally doped with argon, the ratio of the etch rate of the silicon oxide layer to the etch rate of the polysilicon layer may be reduced compared to before the doping. Accordingly, the etch ratio of the polysilicon layer may increase due to argon doping compared to before the doping.

In an embodiment, after the argon doping, the ratio of the etch rate of the doped sacrificial layer to the etch rate of the doped preliminary polysilicon layer (sacrificial layer etch rate/preliminary polysilicon layer etch rate) may be less than about 5.0. For example, the ratio of the etch rate of the doped sacrificial layer to the etch rate of the doped preliminary polysilicon layer may be about 3.0 or less, but embodiments are not limited thereto. The ratio of etch rate may vary depending on the doping conditions of argon, the thickness of the sacrificial layer, and the like. Doping conditions of Argon and a thickness of the sacrificial layer may be chosen to provide a target ratio of etch rate. For example, to achieve the ratio of etch rate of less than about 5.0, the Ar doping conditions are an acceleration voltage of about 30keV and a dose amount of between 1E15 and 9E15, and the thickness of the sacrificial layer is about 500 Å.

Table 1 below shows the comparison of etch rates according to argon doping. In Table 1, Comparative Example may correspond to a case in which an etchant is provided to each of a sacrificial layer and a preliminary polysilicon layer, and Example may correspond to a case in which an etchant is provided after each of a sacrificial layer and a preliminary polysilicon layer is doped with argon. Argon doping conditions in Example are an acceleration voltage of about 10 keV and a dose amount of about 1.0E16.

An etchant used in Comparative Example and Example may correspond to a mixed solution of hydrogen fluoride (HF) having a concentration of about 0.95% and ammonium fluoride (NH₄F) having a concentration of about 10%. In Table 1, the etch rate of the sacrificial layer and the etch rate of the preliminary polysilicon layer may correspond to the thickness etched for a predetermined or selected period of time in each layer. In Table 1, the etch rate ratio may correspond to the ratio of the etch rate of the sacrificial layer and the etch rate of the preliminary polysilicon layer (sacrificial layer etch rate/preliminary polysilicon layer etch rate).

**[Table 1]**

| Classifications | Etch rate of sacrificial layer (Å/sec) | Etch rate of preliminary polysilicon layer (Å/sec) | Ratio of etch rate |
|---|---|---|---|
| Comparative Example | 9.05 | 1.66 | 5.45 |
| Example | 1254 | 4.31 | 2.90 |

Referring to Table 1, the etch rate of Example in which both the sacrificial layer and the polysilicon layer may be doped with argon may increase compared to that of Comparative Example. However, it can be seen that the etch rate ratio of Example doped with argon may be reduced compared to that of Comparative Example etched without argon doping.

For example, the degree of an increase in etch rate due to argon doping may be greater in the preliminary polysilicon layer than in the sacrificial layer, and accordingly, the relative etch rate of the preliminary polysilicon layer of Example doped with argon may increase compared to that of Comparative Example. Accordingly, protruding protrusions may be etched more readily in Example than in Comparative Example.

FIG. 8D illustrates a sacrificial layer region D-SL in which a portion of the sacrificial layer SL (see FIG. 8C) is removed by the provided etchant ETH and a remaining sacrificial layer region R-SL in which etching is in progress. In case that the sacrificial layer SL (see FIG. 8C) is partially removed by the etchant ETH and an upper portion EP-T of the doped protrusion D-EP is exposed, etching may being from the exposed upper portion EP-T. Referring to the results in Table 1, the doped protrusion D-EP portion may be etched at a faster rate than before the doping, and accordingly, the doped protrusion D-EP portion may be selectively etched. For example, the doped protrusion D-EP portion which is protruded compared to the base portion BP (see FIG. 8B) may be first etched, and accordingly, during the etching, the thickness of the protrusions EP (see FIG. 8B) may be effectively reduced while minimizing the reduction in thickness of the base portion BP (see FIG. 8B).

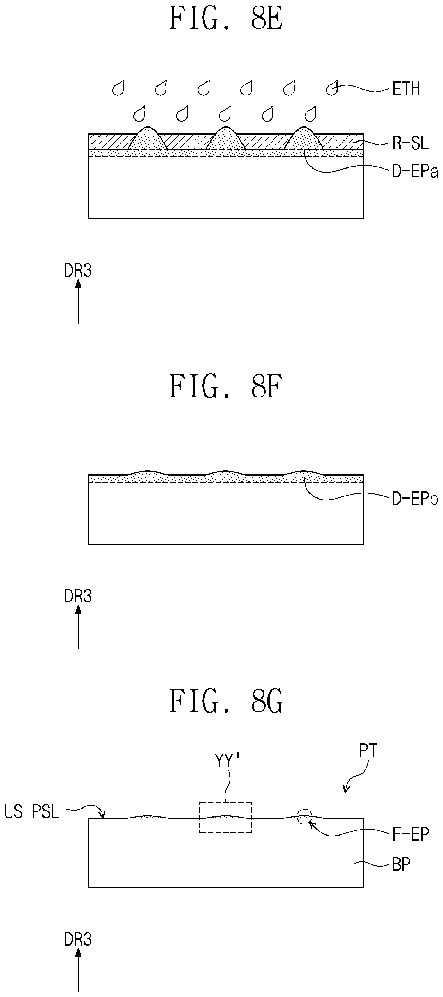

FIG. 8E to FIG. 8G illustrate the operation of removing the sacrificial layer and etching the protrusions to form a polysilicon layer S600. FIG. 8E to FIG. 8G sequentially show changes according to the progress of etching.

FIG. 8E shows the state in which the thickness of a doped protrusion D-EPa may be reduced compared to that of the doped protrusion D-EP illustrated in FIG. 8D, and the thickness of the remaining sacrificial layer region R-SL may also be reduced. For example, as described with reference to Table 1 and the like, as the etch rate of a doped preliminary polysilicon layer increases, etching of the doped protrusion D-EPa may continue while the remaining sacrificial layer region R-SL is still present, so that a change in thickness of the base portion BP (see FIG. 8B) may be minimized.

FIG. 8F illustrates that a doped protrusion D-EPb may additionally be etched after the remaining sacrificial layer region R-SL (see FIG. 8E) is all removed. Although not illustrated in FIG. 8F, a portion of the doped base portion D-BP may be additionally etched in addition to the doped protrusion D-EPb.

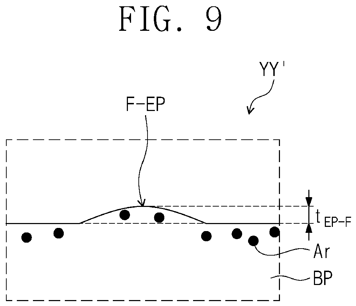

FIG. 8G illustrates a polysilicon layer PT finally formed after the etching process. FIG. 9 illustrates enlarged region YY' of FIG. 8G.

Referring to FIG. 8G and FIG. 9, the polysilicon layer PT may include a protrusion region F-EP partially protruding from the upper surface US-PSL of the base portion BP. The protrusion region F-EP in the polysilicon layer PT may be a portion remaining after the protrusions EP (see FIG. 8A) in the preliminary polysilicon layer are removed by etching.

Compared to the preliminary polysilicon layer P-PT including the protrusions EP protruding from the upper surface US-PSL illustrated in FIG. 8A, the surface roughness of the polysilicon layer PT including the protrusion region F-EP after the etching process may be significantly reduced. For example, a thickness t_{EP-F} of the protrusion region F-EP may be significantly reduced compared to a thickness t_{EP-P} (see FIG. 8A) of the protrusion EP.

The surface roughness at an upper surface of the polysilicon layer PT may be less than about 10 nm. The surface roughness of the upper surface of the polysilicon layer PT may be a root mean square (RMS) value of the thickness of the protrusion region F-EP.

The surface roughness at the upper surface of the polysilicon layer PT may be less than about 50% of the surface roughness at the upper surface of the preliminary polysilicon layer P-PT. For example, in an embodiment, the surface roughness at the upper surface of the preliminary polysilicon layer P-PT may have an RMS value of about 11 nm to about 14 nm, and the surface roughness at the upper surface of the polysilicon layer PT may have an RMS value of about 2 nm to about 5 nm. However, embodiments are not limited thereto, and the value of the surface roughness of a polysilicon layer before and after etching may vary depending on the thickness of a sacrificial layer, the doping amount of argon, and the like. Doping conditions of Argon and a thickness of a sacrificial layer may be chosen to provide a target surface roughness at the upper surface of the polysilicon layer PT. For example, to achieve a surface roughness at the upper surface of the polysilicon layer PT of less than about 50% of the surface roughness at the upper surface of the preliminary polysilicon layer P-PT, the Ar doping conditions are an acceleration voltage of about 30keV and a dose amount of between 1E15 and 9E15, and the thickness of the sacrificial layer is about 500 Å.

FIG. 10B is a view showing a planar image of a polysilicon layer. FIG. 10B shows an image of the polysilicon layer PT taken with a scanning electron microscope (SEM) under the same conditions as those for the planar image of the preliminary polysilicon layer of FIG. 10A. In the image of FIG. 10B, a relatively bright portion may correspond to a portion corresponding to the boundary of crystals. The protrusion region F-EP may be positioned at the boundary of crystals, which is a relatively bright portion. In FIG. 10B, a relatively dark and planar portion may correspond to the base portion BP (see FIG. 8G). For example, FIG. 10B may correspond to a planar image of the polysilicon layer PT illustrated in FIG. 8G.

Referring to the image of FIG. 10B, it can be seen that the thickness of the protrusion EP portion may be reduced compared to the image of FIG. 10A.

Referring back to FIG. 8G and FIG. 9, the polysilicon layer PT may contain argon (Ar). The argon (Ar) may be included adjacent to the upper surface US-PSL of the polysilicon layer PT.

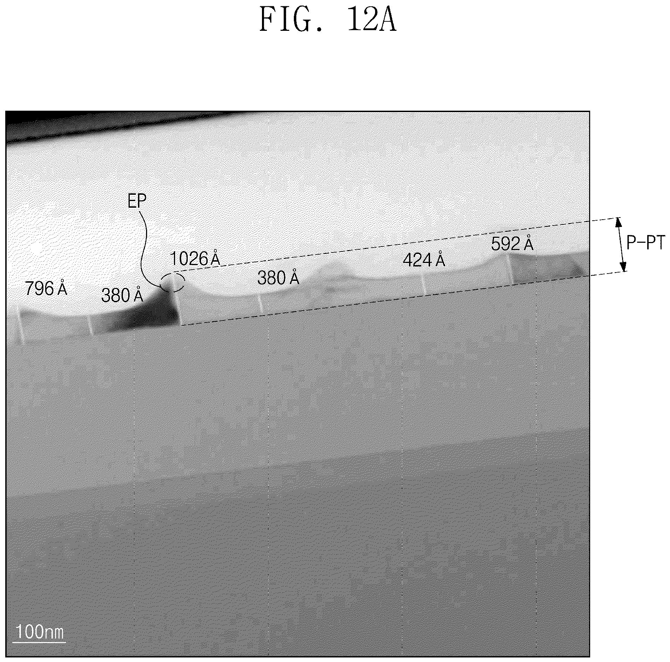

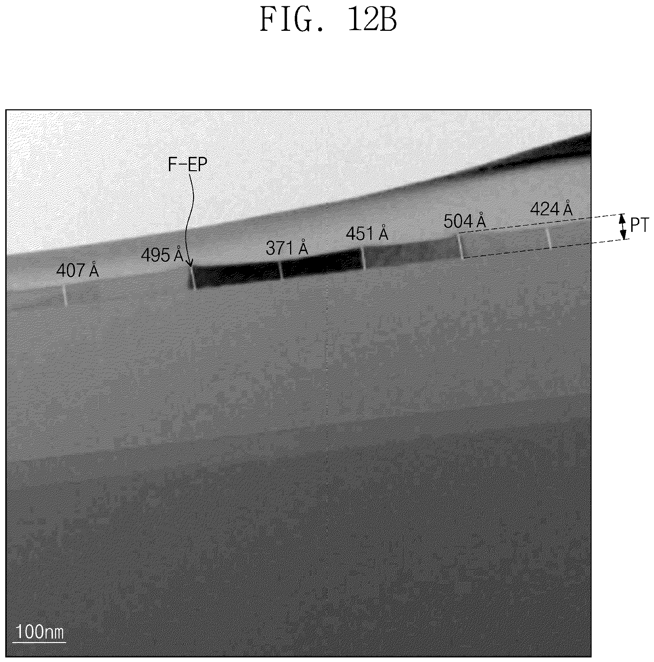

FIG. 12A is a schematic view illustrating a cross-sectional image of a preliminary polysilicon layer, and FIG. 12B is a schematic view illustrating a cross-sectional image of a polysilicon layer according to an embodiment. FIG. 12A and FIG. 12B are images of Transmission Electron Microscopy (TEM). In the images illustrated in FIG. 12A and FIG. 12B, the thickness of each portion is indicated.

Referring to FIG. 12A and FIG. 12B, the protrusions EP formed on the surface of the preliminary polysilicon layer may have a reduced thickness after the argon doping and etching process, and thus, may be changed into a flattened state like the protrusion region F-EP.

Referring to FIG. 12A, the thickness of the preliminary polysilicon layer P-PT in a portion in which the protrusion EP is formed was shown to be about 1026 Å, and referring to FIG. 12B, the thickness of the polysilicon layer PT was shown to be about 495 Å even in a portion including the protrusion region F-EP. For example, referring to FIG. 12A and FIG. 12B, it can be seen that in case etching is performed with an etchant after the argon doping, the protrusion EP portion may be selectively etched, thereby improving surface physical properties of the polysilicon layer.

The method for manufacturing a transistor described with reference to FIG. 7 to FIG. 12B may correspond to a description of an operation of forming the semiconductor pattern SP (see FIG. 6A) of a transistor. The transistor TR (see FIG. 6A) manufactured according to the method for manufacturing a transistor described with reference to FIG. 7 to FIG. 12B and the like may exhibit excellent surface properties, high reliability, and improved electrical properties.

For example, a polysilicon layer manufactured by the manufacturing method of a transistor described with reference to FIG. 7 to FIG. 12B may be included in the semiconductor pattern SP of the transistor TR illustrated in FIG. 6A, and the like. Argon (Ar) provided in the doping operation may remain adjacent to the upper surface US-PSL (see, FIG. 6B) of the semiconductor pattern SP.

A method for manufacturing a display device of an embodiment may correspond to a method for manufacturing the display device ELD including the display module DM illustrated in FIG. 3 and FIG. 6A, and the like. Referring to FIG. 3 to FIG. 9, and the like, the method for manufacturing a display device of an embodiment may include providing a base layer BS, forming a circuit layer DP-CL, and providing a display layer DP-ED.

The operation of forming the circuit layer DP-CL may be an operation of providing the circuit layer DP-CL including transistors TR and insulation layers IOL1 to IOL4, OML1, and OML2 on the base layer BS. The display layer DP-ED may be provided on the circuit layer DP-CL.

The operation of forming the circuit layer DP-CL may include forming an amorphous silicon layer on the base layer, crystallizing the amorphous silicon layer into a preliminary polysilicon layer, providing a sacrificial layer on the preliminary polysilicon layer, doping the sacrificial layer and the preliminary polysilicon layer with argon, providing an etchant on the doped sacrificial layer and the doped preliminary polysilicon layer, and removing the sacrificial layer, and reducing the surface roughness of the preliminary polysilicon layer to form a polysilicon layer.

The operation of forming the circuit layer DP-CL may include the operations of the method for manufacturing a transistor according to an embodiment described above.

The operation of crystallizing the amorphous silicon layer into a preliminary polysilicon layer may include providing an excimer laser to the amorphous silicon layer. A preliminary polysilicon layer P-PT may include protrusions EP formed on the upper surface thereof.

In the operation of providing a sacrificial layer on the preliminary polysilicon layer, a sacrificial layer SL may be provided by covering the protrusions EP. The sacrificial layer SL may include silicon oxide. The average thickness of the provided sacrificial layer SL may be about 300 Å to about 1000 Å.

Argon ions may be provided from an upper portion of the sacrificial layer SL to the sacrificial layer SL and the preliminary polysilicon layer P-PT to dope the sacrificial layer SL and the preliminary polysilicon layer P-PT. The operation of doping the sacrificial layer and the preparatory polysilicon layer with argon may include an operation of providing argon ions with an acceleration voltage of about 5 keV to about 80 keV and a dose amount of about 1.0E15 to about 1.0E20 using an ion implantation facility.

The etchant provided in the operation of providing an etchant on the doped sacrificial layer and the doped preliminary polysilicon layer may be an acidic solution. The provided etchant may contain HF and NH₄F.

After the etchant is provided, a polysilicon layer PT may be formed by removing the sacrificial layer SL and etching the protrusions EP of the preliminary polysilicon layer P-PT. The thickness of the protrusions EP may be reduced in the operation of forming the polysilicon layer PT, so that the surface roughness of the polysilicon layer PT may be reduced.

In the case of the method for manufacturing a display device of an embodiment, at least one of the transistors of the display device may include the polysilicon layer PT.

In the method for manufacturing a display device of an embodiment, the operation of forming a circuit layer may include a transistor manufacturing operation including providing a gate insulation layer IOL1 on a polysilicon layer, forming a gate GT overlapping the polysilicon layer on the gate insulation layer, and forming the polysilicon layer as a semiconductor pattern SP divided into a source SE, a channel AC, and a drain DE.

In a display device manufactured by the method for manufacturing a display device of an embodiment, at least one of multiple transistors may include a polysilicon layer formed by performing an etching process to reduce the thickness of protrusions after argon doping. For example, the method for manufacturing a display device according to an embodiment may provide a display device with improved reliability and improved display quality by allowing a polysilicon layer included in a transistor to have improved surface properties while maintaining excellent mobility properties and physical properties.

The transistor manufacturing method of an embodiment and the display device manufacturing method of an embodiment may include providing argon ions from an upper portion of a sacrificial layer to dope a preliminary polysilicon layer on which the sacrificial layer and protrusions are formed, providing an etchant to an upper portion of the doped sacrificial layer, and removing the sacrificial layer and etching the protrusions to form a polysilicon layer to reduce the thickness of the protrusions on an upper surface of the polysilicon layer, and thus, may exhibit improved surface properties while maintaining excellent physical properties of the polysilicon layer.

The display device of an embodiment may include a transistor manufactured by the transistor manufacturing method of an embodiment, and thus, may exhibit excellent transistor performance, and may exhibit improved display quality.

A method for manufacturing a transistor of an embodiment may provide a transistor having excellent properties by providing argon (Ar) ions in an upper portion of a sacrificial layer to dope the sacrificial layer and polysilicon, and providing an etchant to the upper portion of the doped sacrificial layer to effectively remove protrusions in an upper portion of the polysilicon.

A method for manufacturing a display device of an embodiment may provide a display device having excellent reliability and display quality by providing argon (Ar) ions in an upper portion of a sacrificial layer to dope the sacrificial layer and polysilicon during an operation of forming a circuit layer, and forming a transistor including a polysilicon layer formed by providing an etchant to the upper portion of the doped sacrificial layer to effectively remove protrusions in an upper portion of the polysilicon.

A display device of an embodiment may exhibit excellent reliability and display quality by including a transistor including a semiconductor pattern having excellent surface properties.

Embodiments have been disclosed herein, and although terms are employed, they are used and are to be interpreted in a generic and descriptive sense only and not for purpose of limitation. In some instances, as would be apparent by one of ordinary skill in the art, features, characteristics, and/or elements described in connection with an embodiment may be used singly or in combination with features, characteristics, and/or elements described in connection with other embodiments unless otherwise specifically indicated. Accordingly, it will be understood by those of ordinary skill in the art that various changes in form and details may be made without departing from the scope of the disclosure.

Further Embodiments are set out in the following clauses:
Clause 1. A method for manufacturing a transistor, the method comprising:
   providing a preliminary polysilicon layer including an upper surface on which protrusions are formed;
   providing a sacrificial layer on the upper surface of the preliminary polysilicon layer;
   providing argon (Ar) ions in an upper portion of the sacrificial layer to dope the sacrificial layer and the preliminary polysilicon layer;
   providing an etchant to an upper portion of the doped sacrificial layer; and
   removing the sacrificial layer, and etching the protrusions to form a polysilicon layer.
Clause 2. The method of clause 1, wherein a surface roughness of an upper surface of the polysilicon layer is less than about 50% of a surface roughness of the upper surface of the preliminary polysilicon layer.
Clause 3. The method of clause 1 or clause 2, wherein the preliminary polysilicon layer is formed in an operation of performing crystallization by providing an excimer laser to an amorphous silicon layer.
Clause 4. The method of any preceding clause, wherein the sacrificial layer comprises silicon oxide (SiOx).
Clause 5. The method of clause 4, wherein an average thickness of the sacrificial layer is in a range of about 300 Å to about 1000 Å.
Clause 6. The method of clause 5, wherein the providing of the argon ions comprises providing the argon ions with an acceleration voltage in a range of about 5 keV to about 80 keV, and a dose amount in a range of about 1.0E15 to about 1.0E20 in an ion implantation facility.
Clause 7. The method of any preceding clause, wherein the etchant is an acidic solution containing hydrogen fluoride (HF) and ammonium fluoride (NH₄F).
Clause 8. The method of any preceding clause, wherein a ratio of an etch rate of the doped sacrificial layer to an etch rate of the doped preliminary polysilicon layer is less than about 5.0.
Clause 9. A display device, comprising:
   a base layer;
   a circuit layer disposed on the base layer, and including a transistor and insulation layers; and
   a display layer disposed on the circuit layer, and including a light emitting element electrically connected to the transistor,
   wherein the transistor includes a polysilicon layer including argon (Ar).
Clause 10. The display device of clause 9, wherein the transistor comprises:
   a semiconductor pattern including:
      a source;
      a channel; and
      a drain, and
   a gate disposed overlapping the semiconductor pattern,
   wherein the semiconductor pattern is the polysilicon layer including the argon.
Clause 11. The display device of clause 10, wherein
   the circuit layer comprises a gate insulation layer disposed between the semiconductor pattern and the gate,
   the gate is disposed on an upper side of the semiconductor pattern with the gate insulation layer disposed between the gate and the semiconductor pattern, and
   at least part of the semiconductor pattern that is adjacent to the gate insulation layer includes the argon.
Clause 12. The display device of any one of clauses 9 - 11, wherein a surface roughness of the polysilicon layer is about 10 nm or less.
Clause 13. A method for manufacturing a display device, the method comprising:
   providing a base layer;
   forming, on the base layer, a circuit layer including transistors and insulation layers; and
   providing a display layer on the circuit layer,
   wherein the forming of the circuit layer includes:
      forming an amorphous silicon layer on the base layer; crystallizing the amorphous silicon layer into a preliminary polysilicon layer;
      providing a sacrificial layer on the preliminary polysilicon layer;
      doping the sacrificial layer and the preliminary polysilicon layer with argon;
      providing an etchant on the doped sacrificial layer and the doped preliminary polysilicon layer; and
      removing the sacrificial layer, and reducing a surface roughness of the preliminary polysilicon layer to form a polysilicon layer.
Clause 14. The method of clause 13, wherein at least one of the transistors comprises the polysilicon layer.
Clause 15. The method of clause 14, wherein the forming of the circuit layer further includes:
   manufacturing a transistor by:
   providing a gate insulation layer on the polysilicon layer;
   forming a gate overlapping the polysilicon layer on the gate insulation layer; and
   forming the polysilicon layer as a semiconductor pattern divided into a source, a channel, and a drain.
Clause 16. The method of any one of clauses 13 - 15, wherein the crystallizing of the amorphous silicon layer comprises providing an excimer laser to the amorphous silicon layer.
Clause 17. The method of any one of clauses 13 - 16, wherein the sacrificial layer comprises silicon oxide (SiOx).
Clause 18. The method of clause 17, wherein an average thickness of the sacrificial layer is in a range of about 300 Å to about 1000 Å.
Clause 19. The method of clause 18, wherein the doping of the sacrificial layer comprises providing argon ions with an acceleration voltage in a range of about 5 keV to about 80 keV, and a dose amount in a range of about 1.0E15 to about 1.0E20 in an ion implantation facility.
Clause 20. The method of any one of clauses 13 - 19, wherein the etchant is an acidic solution containing hydrogen fluoride (HF) and ammonium fluoride (NH₄F).

## Claims

1. A method for manufacturing a transistor, the method comprising:
providing a preliminary polysilicon layer including an upper surface on which protrusions are formed;
providing a sacrificial layer on the upper surface of the preliminary polysilicon layer;
providing argon (Ar) ions in an upper portion of the sacrificial layer to dope the sacrificial layer and the preliminary polysilicon layer;
providing an etchant to an upper portion of the doped sacrificial layer; and
removing the sacrificial layer, and etching the protrusions to form a polysilicon layer.

2. The method of claim 1, wherein a surface roughness of an upper surface of the polysilicon layer is less than about 50% of a surface roughness of the upper surface of the preliminary polysilicon layer.

3. The method of claim 1 or claim 2, wherein the preliminary polysilicon layer is formed in an operation of performing crystallization by providing an excimer laser to an amorphous silicon layer.

4. The method of any preceding claim, wherein the sacrificial layer comprises silicon oxide (SiOx).

5. The method of claim 4, wherein an average thickness of the sacrificial layer is in a range of about 300 Å to about 1000 Å.

6. The method of claim 5, wherein the providing of the argon ions comprises providing the argon ions with an acceleration voltage in a range of about 5 keV to about 80 keV, and a dose amount in a range of about 1.0E15 to about 1.0E20 in an ion implantation facility.

7. The method of any preceding claim, wherein the etchant is an acidic solution containing hydrogen fluoride (HF) and ammonium fluoride (NH₄F).

8. The method of any preceding claim, wherein a ratio of an etch rate of the doped sacrificial layer to an etch rate of the doped preliminary polysilicon layer is less than about 5.0.

9. A display device, comprising:
a base layer;
a circuit layer disposed on the base layer, and including a transistor and insulation layers; and
a display layer disposed on the circuit layer, and including a light emitting element electrically connected to the transistor,
wherein the transistor includes a polysilicon layer including argon (Ar).

10. The display device of claim 9, wherein the transistor comprises:
a semiconductor pattern including:
a source;
a channel; and
a drain, and
a gate disposed overlapping the semiconductor pattern,
wherein the semiconductor pattern is the polysilicon layer including the argon.

11. The display device of claim 10, wherein
the circuit layer comprises a gate insulation layer disposed between the semiconductor pattern and the gate,
the gate is disposed on an upper side of the semiconductor pattern with the gate insulation layer disposed between the gate and the semiconductor pattern, and
at least part of the semiconductor pattern that is adjacent to the gate insulation layer includes the argon.

12. The display device of any one of claims 9 - 11, wherein a surface roughness of the polysilicon layer is about 10 nm or less.

13. A method for manufacturing a display device, the method comprising:
providing a base layer;
forming, on the base layer, a circuit layer including transistors and insulation layers; and
providing a display layer on the circuit layer,
wherein the forming of the circuit layer comprises a method for manufacturing a transistor according to any one of claims 1-8, wherein providing the preliminary polysilicon layer comprises forming an amorphous silicon layer on the base layer and crystallizing the amorphous silicon layer into the preliminary polysilicon layer.

14. The method of claim 13, wherein the
manufacturing the transistor further comprises:
providing a gate insulation layer on the polysilicon layer;
forming a gate overlapping the polysilicon layer on the gate insulation layer; and
forming the polysilicon layer as a semiconductor pattern divided into a source, a channel, and a drain.
